(19) Europäisches Patentamt

European Patent Office

Office européen des brevets

(11) **EP 3 381 093 B1**

(12) **EUROPEAN PATENT SPECIFICATION**

(45) Date of publication and mention
of the grant of the patent:
**21.10.2020 Bulletin 2020/43**

(21) Application number: **16869041.0**

(22) Date of filing: **26.10.2016**

(51) Int Cl.:
*H01R 13/6473* (2011.01)     *H01R 24/64* (2011.01)
*H01R 13/6461* (2011.01)     *H01R 107/00* (2006.01)
*H05K 1/16* (2006.01)        *H05K 1/02* (2006.01)
*H01R 13/6466* (2011.01)

(86) International application number:
**PCT/US2016/058793**

(87) International publication number:
**WO 2017/091316 (01.06.2017 Gazette 2017/22)**

(54) **COMMUNICATIONS CONNECTORS INCLUDING TRANSMISSION LINES HAVING IMPEDANCE DISCONTINUITIES THAT IMPROVE RETURN LOSS AND/OR INSERTION LOSS PERFORMANCE AND RELATED METHODS**

KOMMUNIKATIONSVERBINDER MIT ÜBERTRAGUNGSLEITUNGEN MIT IMPEDANZDISKONTINUITÄTEN ZUR VERBESSERUNG DER RÜCKFLUSSDÄMPFUNGS- UND EINFÜGUNGSDÄMPFUNGSLEISTUNG UND ZUGEHÖRIGE VERFAHREN

CONNECTEURS DE COMMUNICATION COMPRENANT DES LIGNES DE TRANSMISSION À DISCONTINUITÉS D'IMPÉDANCE AMÉLIORANT LES PERFORMANCES EN TERMES D'AFFAIBLISSEMENT DE RÉFLEXION ET/OU D'AFFAIBLISSEMENT D'INSERTION, ET PROCÉDÉS ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.11.2015 US 201514949958**

(43) Date of publication of application:
**03.10.2018 Bulletin 2018/40**

(73) Proprietor: **CommScope, Inc. of North Carolina Hickory, North Carolina 28601 (US)**

(72) Inventor: **SCHUMACHER, Richard A. Dallas, Texas 75248 (US)**

(74) Representative: **Parker, Andrew James Meissner Bolte Patentanwälte Rechtsanwälte Partnerschaft mbB Postfach 86 06 24 81633 München (DE)**

(56) References cited:
**EP-A1- 1 347 475        EP-A2- 1 113 459
KR-A- 20110 044 772     US-A1- 2004 263 308
US-A1- 2005 254 223     US-A1- 2006 226 943
US-A1- 2010 190 357     US-A1- 2013 210 289
US-A1- 2014 011 393     US-A1- 2014 206 240
US-A1- 2014 206 240**

## Description

FIELD OF THE INVENTION

The present invention relates generally to communications connectors and, more particularly, to communications connectors such as modular plugs that may exhibit improved return loss and/or insertion loss performance.

BACKGROUND

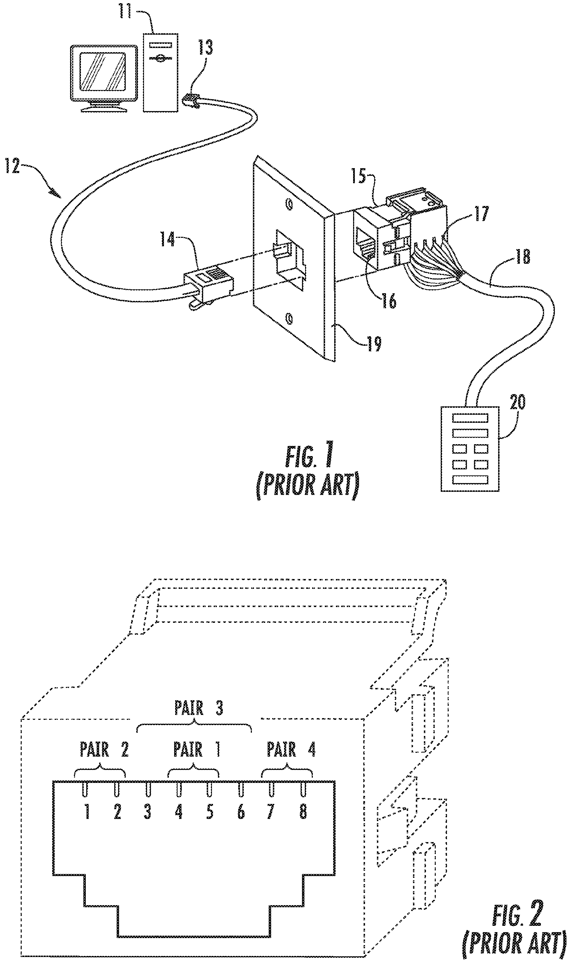

Many hardwired communications systems use plug and jack connectors to connect a communications cable to another communications cable or to a piece of equipment such as a computer, printer, server, switch or patch panel. By way of example, high speed communications systems routinely use such plug and jack connectors to connect computers, printers and other devices to local area networks and/or to external networks such as the Internet. **FIG. 1** depicts a highly simplified example of such a hardwired high speed communications system that illustrates how plug and jack connectors may be used to interconnect a computer **11** to, for example, a network server **20**.

As shown in **FIG. 1,** the computer **11** is connected by a cable **12** to a communications jack **15** that is mounted in a wall plate **19**. The cable **12** is a patch cord that includes a communications plug **13, 14** at each end thereof. Typically, the cable **12** includes eight insulated conductors. As shown in **FIG. 1**, plug **14** is inserted into an opening or "plug aperture" **16** in the front side of the communications jack **15** so that the contacts or "plug blades" of communications plug **14** mate with respective contacts of the communications jack **15**. If the cable **12** includes eight conductors, the communications plug **14** and the communications jack **15** will typically each have eight contacts. The communications jack **15** includes a wire connection assembly **17** at the back end thereof that receives a plurality of conductors (e.g., eight) from a second cable **18** that are individually pressed into slots in the wire connection assembly **17** to establish mechanical and electrical connections between each conductor of the second cable **18** and a respective one of a plurality of conductive paths through the communications jack **15**. The other end of the second cable **18** is connected to a network server **20** which may be located, for example, in a telecommunications closet of a commercial office building. Communications plug **13** similarly is inserted into the plug aperture of a second communications jack (not pictured in **FIG. 1**) that is provided in the back of the computer **11**. Thus, the patch cord **12**, the cable **18** and the communications jack **15** provide a plurality of electrical paths between the computer **11** and the network server **20**. These electrical paths may be used to communicate electrical information signals between the computer **11** and the network server **20**.

When signals are transmitted over a conductor (e.g., an insulated copper wire) in a communications cable, electrical noise from external sources may be picked up by the conductor, degrading the quality of the signal. In order to counteract such noise sources, the information signals in the above-described communications systems are typically transmitted between devices over a pair of conductors (hereinafter a "differential pair" or simply a "pair") rather than over a single conductor. The two conductors of each differential pair are twisted tightly together in the communications cables and patch cords so that the eight conductors are arranged as four twisted differential pairs of conductors. The signals transmitted on each conductor of a differential pair have equal magnitudes, but opposite phases, and the information signal is embedded as the voltage difference between the signals carried on the two conductors of the pair. When the signal is transmitted over a twisted differential pair of conductors, each conductor in the differential pair often picks up approximately the same amount of noise from these external sources. Because approximately an equal amount of noise is added to the signals carried by both conductors of the twisted differential pair, the information signal is typically not disturbed, as the information signal is extracted by taking the difference of the signals carried on the two conductors of the differential pair, and this subtraction process may mostly cancel out the noise signal.

Referring again to **FIG. 1**, it can be seen that a series of plugs, jacks and cable segments connect the computer **11** to the server **20**. Each plug, jack and cable segment includes four differential pairs, and thus a total of four differential transmission lines are provided between the computer **11** and the server **20** that may be used to carry two way communications therebetween (e.g., two of the differential pairs may be used to carry signals from the computer **11** to the server **20**, while the other two may be used to carry signals from the server **20** to the computer **11**). Unfortunately, the proximities of the conductors and contacting structures within each plug-jack connection (e.g., where plug **14** mates with jack **15**) can produce capacitive and/or inductive couplings. These capacitive and inductive couplings in the connectors (and similar couplings that may arise in the cabling) give rise to another type of noise that is known as "crosstalk."

In particular, "crosstalk" refers to unwanted signal energy that is capacitively and/or inductively coupled onto the conductors of a first "victim" differential pair from a signal that is transmitted over a second "disturbing" differential pair. The induced crosstalk may include both near-end crosstalk (NEXT), which is the crosstalk measured at an input location corresponding to a source at the same location (i.e., crosstalk whose induced voltage signal travels in an opposite direction to that of an originating, disturbing signal in a different path), and far-end crosstalk (FEXT), which is the crosstalk measured at the output location corresponding to a source at the input location (i.e., crosstalk whose signal travels in the same direction as the disturbing signal in the different path). Both types of crosstalk comprise an undesirable noise signal that interferes with the information signal that is transmitted over the victim differential pair.

While methods are available that can significantly reduce the effects of crosstalk within communications cable segments, the communications connector configurations that were adopted years ago - and which still are in effect in order to maintain backwards compatibility - generally did not maintain the arrangement and geometry of the conductors of each differential pair so as to minimize the crosstalk coupling between the differential pairs in the connector hardware. For example, pursuant to the ANSI/TIA-568-C.2 standard approved August 11, 2009 by the Telecommunications Industry Association (also known as the Category 6a standard), in the connection region where the blades of a modular plug mate with the contacts of the modular jack (referred to herein as the "plug-jack mating region"), the eight conductors **1-8** must be aligned in a row, with the eight conductors **1-8** arranged as four differential pairs specified as depicted in **FIG. 2**. As is apparent from **FIG. 2**, this arrangement of the eight conductors **1-8** will result in unequal coupling between the differential pairs, and hence both NEXT and FEXT is introduced in each connector in industry standardized communications systems.

As the operating frequencies of communications systems has increased, crosstalk in the plug and jack connectors has became a more significant problem. To address this problem, communications jacks now routinely include compensating crosstalk circuits that introduce compensating crosstalk that was used to cancel much of the "offending" crosstalk that is introduced in the plug-jack mating region as a result of the industry-standardized connector configurations. Initially, so-called "single-stage" crosstalk compensation circuits were developed that could cancel the "offending" crosstalk that is generated in a plug-jack connector because a first conductor of a first differential pair couples more heavily with a first of the two conductors of a second differential pair than does the second conductor of the first differential pair. Typically, these single-stage crosstalk compensation circuits were implemented by configuring the jack so that the second conductor of the first differential pair would couple with the first of the two conductors of the second differential pair later in the jack to provide a "compensating" crosstalk signal. As the first and second conductors of the differential pair carry equal magnitude, but opposite phase signals, so long as the magnitude of the "compensating" crosstalk signal that is induced in such a fashion is equal to the magnitude of the "offending" crosstalk signal, then the compensating crosstalk signal that is introduced later in the jack may substantially cancel out the offending crosstalk signal.

While the above-described "single-stage" crosstalk compensation circuits were generally effective at cancelling out most of the crosstalk for low frequency signals (e.g., below 100 MHz), as the industry moved to higher frequency signals the phase change between the offending crosstalk signal and the compensating crosstalk signal became more significant such that it became difficult to achieve sufficient crosstalk compensation. Consequently, the use of "multi-stage" crosstalk compensation schemes became common. Such crosstalk schemes are described in U.S. Patent No. 5,997,358 to Adriaenssens et al.

Work is now ongoing in the industry to develop a Category 8 standard that will specify parameters for higher data rate communications plugs, jacks and cable segments that may operate at higher frequencies. For example, the above-referenced ANSI/TIA-568-C.2 Category 6a standard provides for communications at frequencies up to 500 MHz. In contrast, it is anticipated that the Category 8 standard may call for communications at frequencies up to, for example, 2 GHz. Moreover, it is anticipated that Category 8 connectors (e.g., plug and jacks) may be required to exhibit full backwards compatibility so that they may be used with conventional Category 6 or 6a connectors while meeting the component and channel performance requirements set forth in the Category 6 and 6a standards. Special challenges may be involved in providing communications connectors that can meet the Category 8 performance standards over the full anticipated Category 8 frequency range while also providing full backwards compatibility.

The prior art document US 2013/210289 A1 discloses communications connectors such as modular plugs that may exhibit improved crosstalk, return loss and/or insertion loss performance.

The prior art document EP 1 347 475 A1 discloses a method for producing a multilayer substrate or an electronic part as well as an electronic part wherein decrease in the layer thickness has been enabled.

The prior art document US 2006/226943 A1 discloses techniques using magnetically differential inductors to reduce interference in a circuit.

Claim 1 discloses a communication connector according to the invention. Dependent claims 2-13 describe different embodiments of the invention.

BRIEF DESCRIPTION OF THE DRAWINGS

    FIG. 1 is a simplified schematic diagram illustrating the use of conventional communications plugs and jacks to interconnect a computer with network equipment.

    FIG. 2 is a schematic diagram illustrating the modular jack contact wiring assignments for a conventional 8-position communications jack (TIA 568B) as viewed from the front opening of the jack.

    FIG. 3 is a circuit diagram of a model of a conventional differential transmission line through a communications plug.

    FIG. 4A is a graph illustrating the return loss of a first plug that does not use the return loss improvement techniques according to embodiments of the present invention and of a second plug that uses the return loss techniques according to embodiments of the present invention.

**FIG. 4B** is a graph illustrating the insertion loss of a first plug that does not use the return loss improvement techniques according to embodiments of the present invention and of a second plug that uses the return loss techniques according to embodiments of the present invention.

**FIG. 5** is a circuit diagram of a model of a differential transmission line through a communications plug that includes impedance imbalances that improve return loss performance over a selected frequency band.

**FIG. 6** is a graph that illustrates the currents into a load capacitor of the transmission line of **FIG. 5** as a function of frequency.

**FIG. 7** is a perspective view of a patch cord according to certain embodiments of the present invention.

**FIG. 8** is a top-rear perspective view of a plug that is included on the patch cord of **FIG. 7**.

**FIG. 9** is a bottom-rear perspective view of the plug of **FIG. 8**.

**FIG. 10** is a side view of the plug of **FIG. 8**.

**FIGS. 11-14** are various perspective views of a printed circuit board of the plug of **FIGS. 7-10**.

**FIG. 15** is a graph illustrating the simulated return loss performance of the communications plug of **FIGS. 8-14**.

**FIG. 16** is a circuit diagram of a model of a differential transmission line through a communications plug that illustrates how the impedance imbalances may alternatively be implemented using discrete reactive components.

**FIG. 17** is a graph illustrating the close match in the return loss performance of the transmission lines of **FIGS. 5** and **16**.

**FIG. 18** is a flow chart illustrating operations for designing a transmission line through a communications connector according to embodiments of the present invention.

**FIG. 19** is a circuit diagram of a model of a conventional Cat 6A test plug.

**FIG. 20** is a graph illustrating the simulated return loss performance of the transmission lines of the communications plug of **FIG. 19**.

**FIG. 21** is a circuit diagram of a model of the Cat 6A test plug of **FIG. 19** that further includes discrete elements that provide return loss and insertion loss enhancements.

**FIG. 22** is a graph illustrating the simulated return loss performance of the transmission lines of the communications plug of **FIG. 21**.

**FIG. 23** is a graph illustrating the simulated return loss performance of the transmission lines of a model of the Cat 6A test plug of **FIG. 19** that includes both discrete elements and transmission line impedance imbalances that together provide return loss and insertion loss enhancements.

**FIG. 24** is a top view of a pair of printed circuit board based solenoid inductors that may be used in communications connectors according to embodiments of the present invention.

**FIG. 25** is an oblique view of the printed circuit board based solenoid inductors of **FIG. 24**.

DETAILED DESCRIPTION

Pursuant to embodiments of the present invention, communications connectors such as communications plugs are provided that may meet crosstalk as well as return loss and insertion loss performance requirements.

As noted above, in communications connectors that include multiple differential pairs, crosstalk is an important performance parameter that impacts the throughput (data rate) that the connector can accommodate. Another important parameter in communications connectors is the return loss that is experienced along each differential pair (i.e., differential transmission line) through the connector. The return loss of a transmission line is a measure of how well the transmission line is impedance matched with a terminating device or with loads that are inserted along the transmission line. In particular, the return loss is a measure of the signal power that is lost due to signal reflections that may occur at discontinuities (impedance mismatches) in the transmission line. Return loss is typically expressed as a ratio in decibels (dB) as follows:

$$RL(\mathrm{dB}) = 10\log_{10}\frac{P_\mathrm{i}}{P_\mathrm{r}}$$

where $RL(\mathrm{dB})$ is the return loss in dB, $P_\mathrm{i}$ is the incident power and $P_\mathrm{r}$ is the reflected power. High return loss values indicate a good impedance match (i.e., little signal loss due to reflection), which results in lower insertion loss values, which is desirable. The industry standards will typically specify minimum return loss requirements for the transmission lines within individual connectors, within mated connectors (i.e., across a mated plug and jack) and/or for an entire communications channel (i.e., for one or more differential transmission lines that extend from computer **11** to server **20** in **FIG. 1** across various connectors and cable segments). As return loss typically decreases with increasing frequency (i.e., the return loss performance gets worse with increasing frequency), the industry standards typically specify minimum return loss values that must be met as a function of frequency for the specified components and/or channels.

In communications systems that include multiple differential transmission lines, it is commonplace for inductive and capacitive couplings to exist between various of the transmission lines. For example, as discussed above, offending crosstalk and compensating crosstalk circuits are routinely provided in plug and jack connectors. Unfortunately, these inductive and capacitive couplings appear as loads along the transmission line that can degrade the return loss of the transmission line.

By way of example, the Category 6 and 6a standards require that standards-compliant communications plugs introduce predetermined amounts of "offending" crosstalk between the four differential pairs thereof. If the Category 8 standard requires backwards compatibility with the Category 6 and 6a standards, then it will be necessary for Category 8 standards-compliant plugs to inject the industry-standardized amounts of offending crosstalk between the four differential transmission lines as well. However, this "offending" crosstalk will appear as loads on each of the differential transmission lines through the plug. Moreover, in order to comply with the crosstalk requirements set forth in the Category 6a standard, it will likely also be necessary to include crosstalk compensation circuits in the Category 8 communications jacks that substantially cancel the offending crosstalk that is generated in the plug. This compensating crosstalk thus will also appear as loads on the four differential transmission lines that pass through the mated plug-jack connectors. It is anticipated that it may be difficult to maintain acceptable return loss performance at higher frequencies (e.g., frequencies above 1 GHz) in a communications plug (or mated plug-jack combination) while also injecting the necessary amount of offending crosstalk between the differential pairs and compensating for the same in the communications jack.

Pursuant to embodiments of the present invention, communications connectors are provided that have signal paths that include one more electrical circuits that create resonances at one or more frequencies. These resonances (including the frequency range over which the resonances occur) may be tuned to enhance the return loss and/or the insertion loss of the signal path within a desired range of frequencies without unacceptably degrading other characteristics of the signal path. The resonant frequencies are not necessarily within the range of frequencies within which return loss and/or insertion loss is enhanced. In fact, in some embodiments the resonance may be so wide that it does not create a peak or local maximum in either the return loss or insertion loss spectra of the signal path. The electrical circuits that generate the resonances can be implemented using, for example, discrete capacitors and inductors and/or using a transmission line containing at least two impedance discontinuities of particular magnitudes separated by a particular electrical length.

In some embodiments, communications connectors are provided that have at least one transmission line that includes pre-selected impedance mismatches that are used to improve the return loss and/or the insertion loss of the transmission line over a desired frequency range. In particular, the transmission line may include at least two locations where impedance mismatches are provided that create resonances. The magnitude of these impedance mismatches and the locations of the impedance mismatches (which determines the time delay between the impedance mismatches and other elements along the transmission line) may be selected to improve the return loss and/or the insertion loss of the transmission line over a selected frequency range such as, for example, from about 1 GHz to about 2 GHz. These designed impedance mismatches and associated delay(s) may create resonances or other effects, including large amounts of signal reflections, at frequency ranges outside of the frequency range of interest. The resonances may be tuned by adjusting the magnitudes of the impedance mismatches and the electrical delays between the impedance mismatches. In some cases, the resonances may create a local maximum in the return loss spectra and/or a local minimum in the insertion loss spectra for the transmission line. These local maxima and minima may (but need not be) within or just outside the frequency range for which the transmission line is designed to operate and may be used to effectively extend the frequency range (to higher frequencies) over which the transmission line may provide suitable return loss performance.

In some embodiments, the connector may be a communications plug. The plug may be designed to have at least two impedance mismatches along at least one of the differential transmission lines through the plug. These impedance mismatches can be implemented in a wide variety of ways. For example, in plugs in which at least part of the transmission lines run across (and perhaps through) a printed circuit board, one or more impedance mismatches may be created by, for example, (1) changing the width, thickness or spacing of the conductive traces/elements on the printed circuit board that form the transmission line segments, (2) varying the distance(s) of the conductors from adjacent image planes, if any, and/or (3) by varying the dielectric constants of the surrounding materials. Impedance mismatches may also or alternatively be implemented at transitions within the plug such as the transition from conductive wires of a communications cable to printed circuit board conductive traces or from printed circuit board conductive traces to the blades of the plug. By carefully selecting the magnitude of these impedance mismatches and the delays between the mismatches it is possible to significantly improve the return loss performance of the transmission line over a selected frequency range.

As noted above, in other embodiments, the time delayed impedance mismatches along the transmission line(s) of the communications connector may be replaced by discrete reactive elements such as capacitors and/or inductors. For example, on a balanced (differential) transmission line discrete reactive elements may be provided along the transmission line that resemble and/or function as a "box-section" filter (i.e., two shunt capacitors between the conductors of the transmission line with a series inductor along each conductor between the two capacitors). For connectors that use single-ended transmission lines, the discrete reactive elements may be arranged as a pi-section filter (i.e., two shunt capacitors with a series inductor therebetween). In still other embodiments, a combination of the time-delayed impedance mismatches and discrete reactive elements may be used to generate the resonances that are tuned to provide improved return loss and insertion loss performance.

In some embodiments, the connectors may comprise Category 8 standard plugs that include coupling components such as capacitors or inductive coupling sections that are used to increase the crosstalk between the differential transmission lines through the plug in order to comply with the offending crosstalk levels specified in the Category 6a standard. As noted above, such coupling components may be provided to ensure that the plug is backwards compatible with the Category 6a standard. In some embodiments, these crosstalk coupling components may be incorporated into the electrical circuit that is provided to improve return loss and/or insertion loss performance. In other embodiments, the connectors may comprise Category 6a plugs. It will also be appreciated that embodiments of the present invention are not limited to Ethernet connectors or to connectors with differential transmission lines. Additionally, while embodiments of the present invention are primarily discussed herein with respect to communications plugs, it will be appreciated that crosstalk compensation is routinely introduced in jacks and that the techniques that are described herein may also be used in jacks to improve the return loss and/or insertion loss performance thereof.

Embodiments of the present invention will now be discussed in greater detail with reference to the drawings.

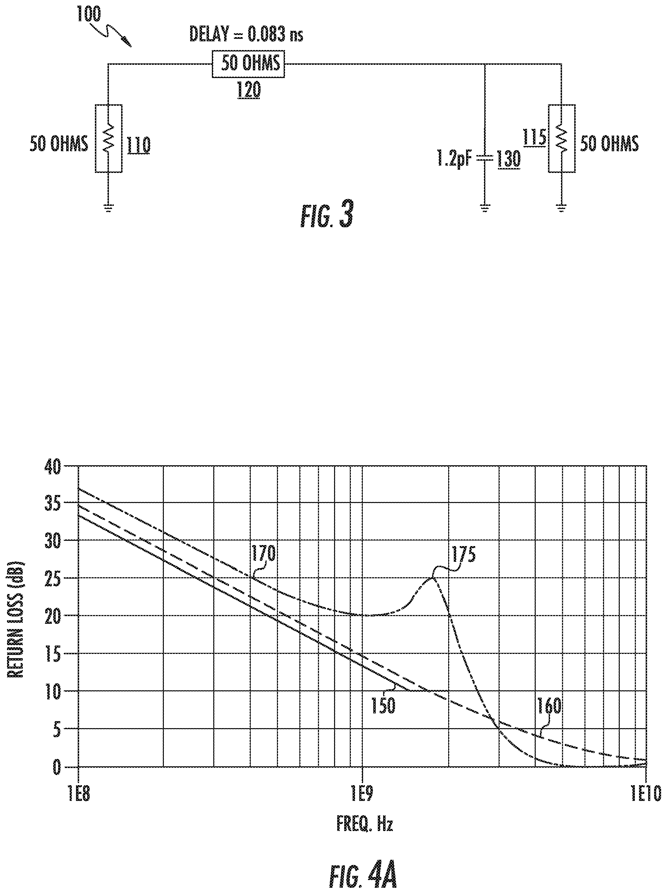

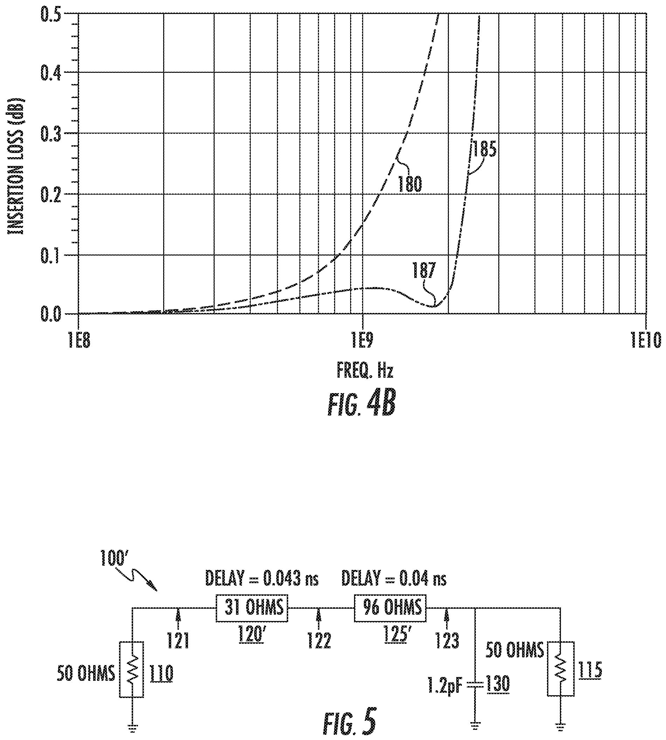

FIG. 3 is a simplified circuit model of a single-ended (i.e., non-differential) 50 ohm transmission line 100 that illustrates how crosstalk circuits (i.e., offending crosstalk or compensating crosstalk components, whether or not intentionally introduced) can create a load along a transmission line. FIG. 4A is a graph illustrating the modeled return loss of the transmission line 100 of FIG. 3 that illustrates how the transmission line 100 may fail to meet the proposed return loss parameter for the Category 8 standard at high frequencies. FIG. 4A also includes a graph illustrating the modeled return loss of a transmission line according to embodiments of the present invention that illustrates the degree to which return loss performance may readily be improved. This graph in FIG. 4A will be discussed below in conjunction with FIG. 5. FIG. 4B is a graph illustrating the modeled insertion loss of the transmission line 100 of FIG. 3 as compared to the modeled insertion loss of a transmission line according to embodiments of the present invention.

As shown in FIG. 3, the transmission line 100 may be modeled as a signal source with internal series termination 110, a transmission line segment 120, a capacitive load 130 and an end termination 115. Each of the terminations 110, 115 are 50 ohm terminations, as is the transmission line segment 120. The transmission line segment 120 has a length that results in a delay of 0.083 nanoseconds (i.e., an RF signal will traverse each transmission line segment in 0.083 nanoseconds). The capacitive load 130 is assumed to be a shunt 1.2 pF capacitance, which is representative of the type of capacitive load that results from the offending crosstalk requirements in the Category 6a standard. While the crosstalk load 130 is modeled as solely comprising capacitive crosstalk, it will be appreciated that the pair-to-pair crosstalk in communications connectors will typically include both a capacitive component and an inductive component. The inductive component of the crosstalk may likewise appear as a load on the transmission line and have similar effects on return loss performance. The effect of the crosstalk is modeled in FIG. 3 as a purely capacitive effect in order to simplify the example and associated modeling.

Referring now to FIG. 4A, one proposed return loss specification for a transmission line through a Category 8 plug is shown as curve 150. As shown in FIG. 4A, a return loss of at least 33 dB is specified at 100 MHz and this minimum return loss requirement drops to about 10 dB at 1.5 GHz, where it remains constant. As is also shown in FIG. 4, the return loss performance of the transmission line 100 of FIG. 3 (curve 160) has a margin of about 1 dB for frequencies below 1.5 GHz, but at frequencies above 1.7 GHz the return loss of the transmission line 100 falls below the proposed standard (curve 150). This degradation in return loss performance at higher frequencies may be attributable to the load imparted by the capacitor 130 on the transmission line 100. As the capacitive load 130 may be necessary to comply with industry standards requirements (e.g., interface specifications, crosstalk specifications), it may be difficult to meet return loss performance standards at higher frequencies, as shown in FIG. 4A.

FIG. 5 illustrates how the techniques according to embodiments of the present invention may be used to improve the return loss of the transmission line 100 of FIG. 3 so that it meets the proposed Category 8 return loss standard with significant margin.

As shown in FIG. 5, the transmission line 100 of FIG. 3 may be replaced with a transmission line 100'. The transmission line 100' includes the same signal source with internal series termination 110, the same end termination 115 and the same capacitive load 130 that are included in the transmission line 100 of FIG. 3. However, the 50 ohm transmission line segment 120 of the transmission line 100 of FIG. 3 is replaced with a pair of transmission line segments 120' and 125'. The impedances of the transmission line segments 120' and 125' and the lengths of these transmission line segments are selected to create impedance mismatches that impact the return loss of transmission line 100' in a desired manner. In this example, the transmission line segment 120'

has an impedance of 31 ohms, and a delay of 0.043 nanoseconds, and the transmission line segment **125'** has an impedance of 96 ohms, and a delay of 0.04 nanoseconds. Thus, a first impedance mismatch **121** is generated at the interface between the termination **110** and the transmission line segment **120'** (where a 50 ohm element and a 31 ohm element interface), a second impedance mismatch **122** is generated at the interface between the transmission line segment **120'** and the transmission line segment **125'** (where a 31 ohm element and a 96 ohm element interface), and a third impedance mismatch **123** is generated at the interface between the transmission line segment **125'** and the end termination **115** (where a 96 ohm element and a 50 ohm element interface).

Referring again to **FIG. 4A**, the curve **170** illustrates the modeled return loss performance of the transmission line **100'**. As shown in **FIG. 4A**, improved return loss is seen at all frequencies below 2.7 GHz, with the return loss performance dropping off more slowly at frequencies between 100 MHz and 1 GHz as compared to the return loss performance of transmission line **100** (curve **160**), and then the return loss performance actually improving for frequencies between about 1 GHz and 1.8 GHz before trending downward again. While Applicant does not intend to be limited to any particular theory of operation, it is believed that the impedance mismatches at each of the interfaces **121-123** in the transmission line **100'** may act like a low pass filter. This may, in some cases, generate a local peak or "maximum" in the return loss spectra (i.e., a plot of return loss as a function of frequency) as illustrated at reference numeral **175** in **FIG. 4A.** It will also be appreciated that while the simplest designs may have low-pass filter characteristics, other designs that more resemble high-pass filters, band-stop filters or band-pass filters may also be used. While the return loss may, in some cases, fall off rapidly on the high frequency side of the local peak **175**, the provision of a local peak **175** in the return loss spectra may allow for significantly improved return loss performance within a frequency range of interest. For example, as shown in **FIG. 4A**, by designing the transmission line **100'** so that the local peak **175** is positioned, for example, at a frequency that is in the upper portion of the frequency range of operation (here, below 2 GHz), excellent return loss performance may be achieved in many cases across the entire operating frequency band.

An ideal, unloaded signal path (not shown in the figures) may theoretically have essentially infinite return loss (i.e., no reflection or signal degradation whatsoever). As shown in **FIG. 4A**, the load imparted on the transmission line **100** by the load capacitor **130** degrades the return loss at all frequencies, and this degradation reaches unacceptable levels (for this particular standard) at frequencies just below 2 GHz. As is also shown in **FIG. 4A**, the resonance created by the impedance mismatches (see curve **170**) can be tuned to enhance return loss performance, especially in the frequency range of about 1 GHz to about 2 GHz, where the crosstalk compensation circuits in a mated plug-jack connector would otherwise significantly degrade return loss performance. By designing the transmission line so that the resonances at least mostly occur at frequencies that are outside the frequency range of interest (i.e., the frequency range that the connector is designed to support communications over), these resonances do not unduly impact the performance of the transmission line. Moreover, as noted above, by varying the magnitude of the impedance mismatches, the number of impedance mismatches and/or the delay between the impedance mismatches it is possible in some embodiments to create local peaks in the return loss spectra within the frequency band of interest. The inclusion of such local peaks in the return loss spectra may be particularly effective in providing a transmission loss that has significantly improved return loss performance.

In some embodiments, the local maximum in the return loss spectra of the differential transmission line may be positioned within the return loss spectra in order to extend the operating frequency range of the patch cord over which a minimum return loss margin may be maintained. For example, the peak **175** is positioned near the upper end of the desired operating range (i.e., near 2 GHz) in order to improve the return loss margin at higher frequencies. In some embodiments, the peak may be positioned in the upper half of the desired frequency operation range (i.e., between 1 GHz and 2 GHz in the example of **FIG. 4A**). In other embodiments, the peak may be positioned at a somewhat frequency above the highest frequency in the desired frequency operation range. For example, the peak may be positioned at a frequency that is outside the desired frequency operating range but that is no more that 50% higher than the highest frequency in the desired frequency operation range (i.e., between 2 GHz and 3 GHz in the example of **FIG. 4A**).

Referring next to **FIG. 4B**, the curve **180** illustrates the modeled insertion loss performance of the transmission line **100** and the curve **185** illustrates the modeled insertion loss performance of the transmission line **100'**. As shown in **FIG. 4B**, significant improvements in insertion loss may also be achieved by the techniques according to embodiments of the present invention. Similar to the return loss spectra of **FIG. 4A**, the techniques according to embodiments of the present invention may provide a local minimum in the insertion loss (identified by reference numeral **187** in **FIG. 4B**). In some embodiments, this local minimum may be positioned, for example, at a frequency that is in the upper portion of the frequency range of operation (here, below 2 GHz) in order to provide excellent insertion loss performance across the entire operating frequency band. As shown in **FIG. 4B**, insertion loss may be improved by 0.5 dB or more in certain frequency ranges.

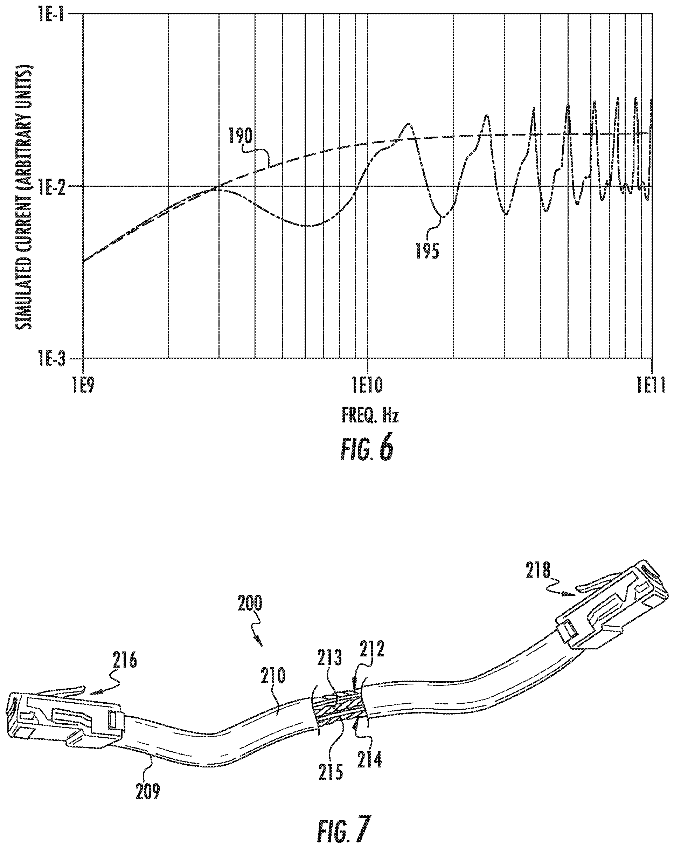

**FIG. 6** illustrates the modeled current flow in the transmission line **100'** of **FIG. 5**. In particular, a current probe was included in the circuit model of **FIG. 5** that measured the current flow, as a function of frequency, into the load capacitor **130**. In **FIG. 6**, curve **190** is the simulated current flow into the load capacitor **130** in the transmission line **100** of **FIG. 3**, while curve **195** is the simulated current flow into the load capacitor **130** in the transmission line **100'** of **FIG. 5**.

As shown in **FIG. 6**, no resonance is found in the current flow into the load capacitor **130** of the transmission line **100** (see curve **190**). However, a resonance appears in the current flow into the load capacitor **130** in the transmission line **100'** of **FIG. 5** (see curve **195**). This resonance is attributable to the impedance mismatch created by the load imparted on the transmission line **100'** by the capacitor **130** together with the electrical length (time delay) of the intentionally added impedance mismatches and their associated time delays along the transmission line **100'**. As shown in **FIG. 6**, the current into the load capacitor **130** may vary widely with frequency. In some embodiments, the transmission line **100'** may be designed so that these resonances occur at frequencies that are outside the frequency range of interest (here frequencies above 2 GHz). This may facilitate ensuring that the resonances do not negatively affect the performance of the transmission line **100'**. Moreover, by varying the magnitude of the impedance mismatches and/or the delay between these impedance mismatches it is possible to create one or more local peaks in the return loss spectra (see peak **175** in **FIG. 4A**) and/or one or more local minimums in the insertion loss spectra (see valley **187** in **FIG.** 4B) within or near the frequency band of interest, thereby providing a transmission line that may exhibit significantly improved return loss and/or insertion loss performance.

The impedance mismatches can be created in a wide variety of ways. As known to those of skill in the art, the impedance of a differential transmission line will be a function of, among other things, the shape of the conductors, the size of the conductors, the material used to form the conductors, the spacing between the conductors, the dielectric constants of the materials surrounding and between the conductors, etc. Thus, the above-described impedance mismatches may be implemented by changing any of these parameters. Trial and error or more deliberate modeling techniques may be used to identify impedance mismatches that provide a desired improvement in return loss performance over a selected frequency band.

For example, computer programs may be used to model the return loss (or insertion loss) of a transmission line through a plug that has one or more loads imparted thereon. The modeling may take into account not only the loads injected on the transmission line by crosstalk circuits and other closely-spaced transmission lines, but may also take into account impedance mismatches that will occur in transitions along the transmission line where, for example, a conductive wire connects to a printed circuit board trace, where insulation is removed from a conductive wire or where a conductive wire mates with a plug blade. One or more of the transmission line segments that extend between the loads may then be changed in the model to have a different impedance and/or a different length. A trial and error process may be used where the lengths and/or the size of the impedance mismatches are varied. The changes in return loss tend to be predictable as this trial and error process is carried out, so a circuit designer can readily identify impedance mismatches and transmission line segment lengths that will provide improved performance over a frequency range of interest. In other embodiments, this process could be automated using, for example, commercially available programs that find local maximum in an output parameter when a variety of input parameters are varied.

In some embodiments, the amount of the impedance mismatch may be at least about 20%. In other embodiments, the amount of the impedance mismatch may be at least about 30%. In still other embodiments, the amount of the impedance mismatch may be at least about 40%. Herein, where references are made to changes in impedance or to impedance mismatches that are specified using a percentage, the percentage is calculated by dividing the difference between the two impedances by the larger of the two impedances. For example, if a first transmission line segment having an impedance of 80 ohms connects to a second transmission line segment that has an impedance of 100 ohms, the change in impedance between these two transmission line segments or, equivalently, the degree of impedance mismatch, would be (100 ohms - 80 ohms)/100 ohms = 20%.

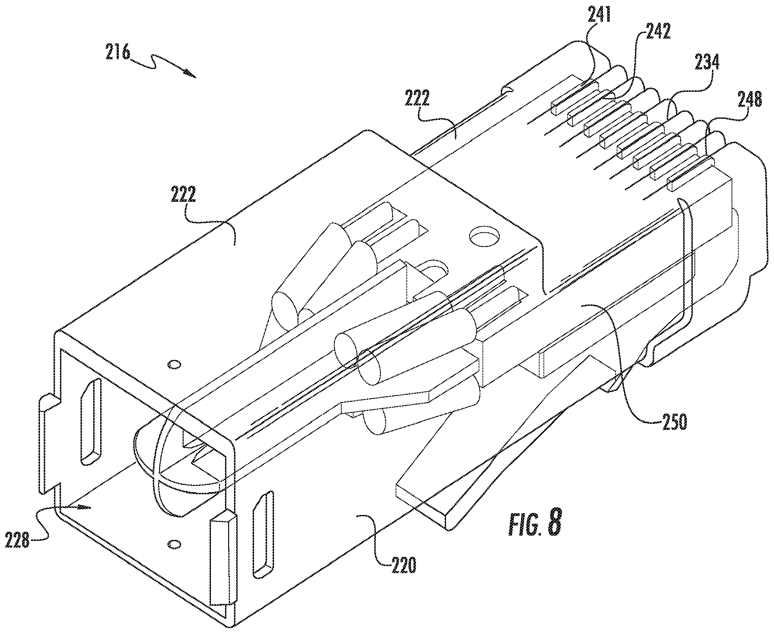

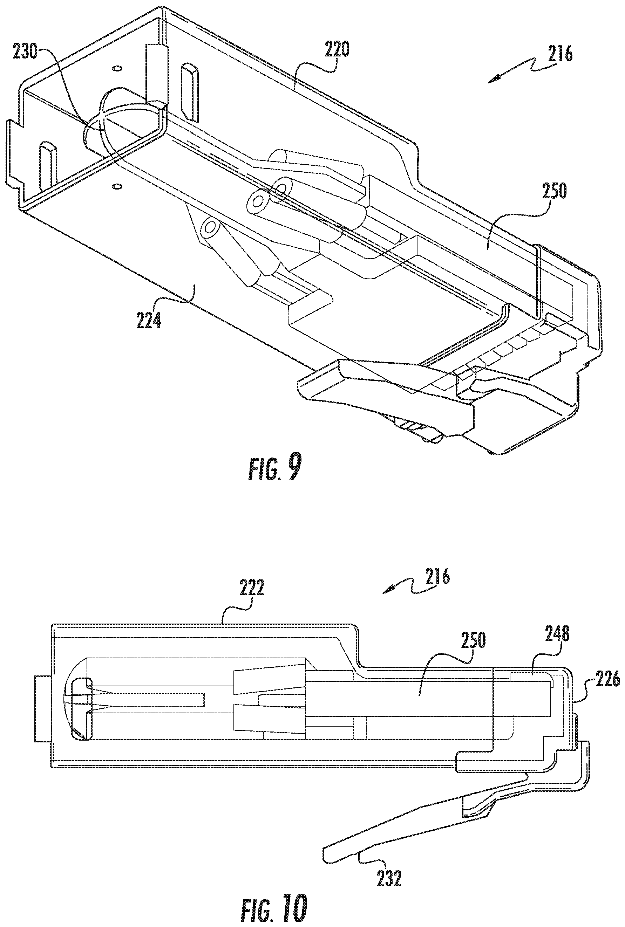

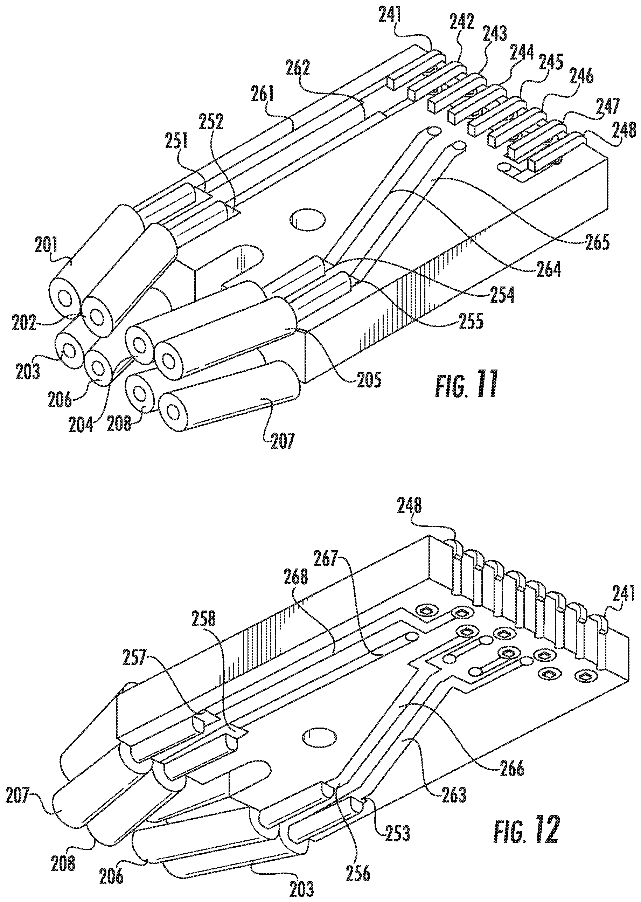

FIGS. 7-14 illustrate a patch cord **200** and various components thereof according to certain embodiments of the present invention. In particular, **FIG. 7** is a perspective view of the patch cord **200**. FIG. 8 is a top-rear perspective view of a plug **216** that is included on the patch cord **200** of **FIG. 7. FIG. 9** is a bottom-rear perspective view of the plug **216**. FIG. 10 is a side view of the plug **216. FIGS. 11-14** are various perspective views of a printed circuit board **250** of plug the **216** of **FIGS. 7-10** that illustrate how the conductors **201-208** of the patch cord **200** connect to the plug blades **241-248** that are mounted on the printed circuit board **250**.

As shown in **FIG. 7**, the patch cord **200** includes a cable **209** that has eight insulated conductors **201-208** enclosed in a jacket **210** (note that the conductors **201-208** are not individually numbered in **FIG. 7**, and conductors **204** and **205** are not visible in **FIG. 7**). The insulated conductors **201-208** may be arranged as four twisted pairs of conductors **211-214** (pair **211** is not visible in **FIG. 7**), with conductors **204** and **205** twisted together to form twisted pair **211**, conductors **201** and **202** twisted together to form twisted pair **212**, conductors **203** and **206** twisted together to form twisted pair **213**, and conductors **207** and **208** twisted together to form twisted pair **214**. A separator **215** such as a tape separator or a cruciform separator may be provided that separates one or more of the twisted pairs **211-214** from one or more of the other twisted pairs **211-214**. A first plug **216** is attached to a first end of the cable **209** and a second plug **218** is attached to the second end of the cable **209** to form the patch cord **200**. Strain relief boots (not shown in **FIG. 7**) may be attached to each of the plugs **216, 218** which resist the tendency for a longitudinal force applied to the cable **209** to pull the cable **209** but of the plugs **216, 218**.

**FIGS. 8-10** are enlarged views that illustrate the first plug **216** of the patch cord **200**. In order to simplify the drawing, a rear cap of the plug housing, various wire grooming and wire retention mechanisms and the strain relief boot are not shown in **FIGS. 8-10**. As shown in **FIGS. 8-10**, the communications plug **216** includes a housing **220** that has a bi-level top face **222**, a bottom face **224**, a front face **226**, and a rear opening **228** that receives a rear cap (not shown). A plug latch **232** extends from the bottom face **224**. The top and front faces **222, 226** of the housing **220** include a plurality of longitudinally extending slots **234**. The communications cable **209** (see **FIG. 7**) is received through the rear opening **228**. A rear cap (not shown) that includes a cable aperture locks into place over the rear opening **228** of housing **220** after the communications cable **209** has been inserted therein.

As is also shown in **FIGS. 8-10**, the communications plug **216** further includes a printed circuit board **250** which is disposed within the housing **220**, and a plurality of plug blades **241-248** are mounted at the forward edge of the printed circuit board **250** so that the blades **241-248** can be accessed through the slots **234** in the top face **222** and front face **226** of the housing **220**. The housing **220** may be made of a suitable insulative plastic material that meets applicable standards with respect to, for example, electrical breakdown resistance and flammability such as, for example, polycarbonate, ABS, ABS/polycarbonate blend or other dielectric molded materials. Any conventional housing **220** may be used that is configured to hold the printed circuit board **250**, and hence the housing **220** is not described in further detail herein.

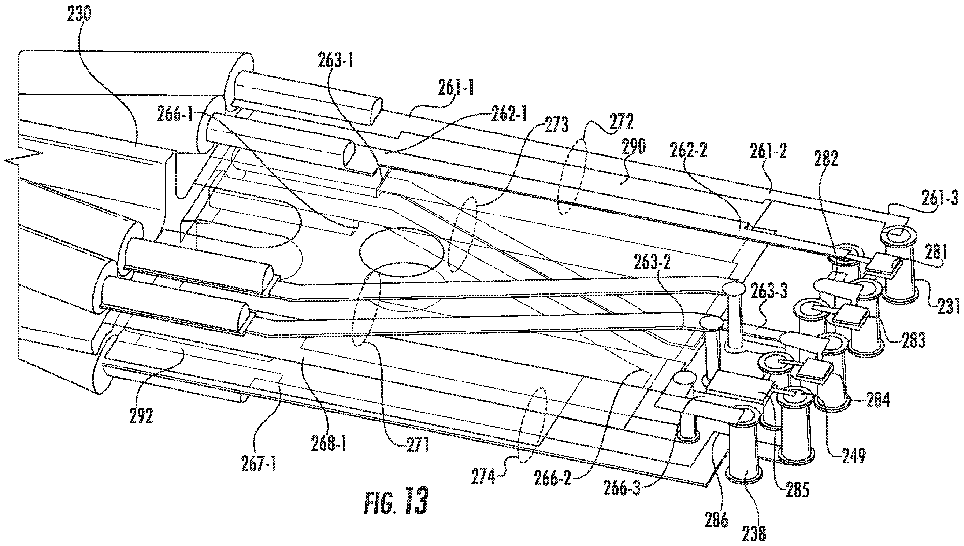

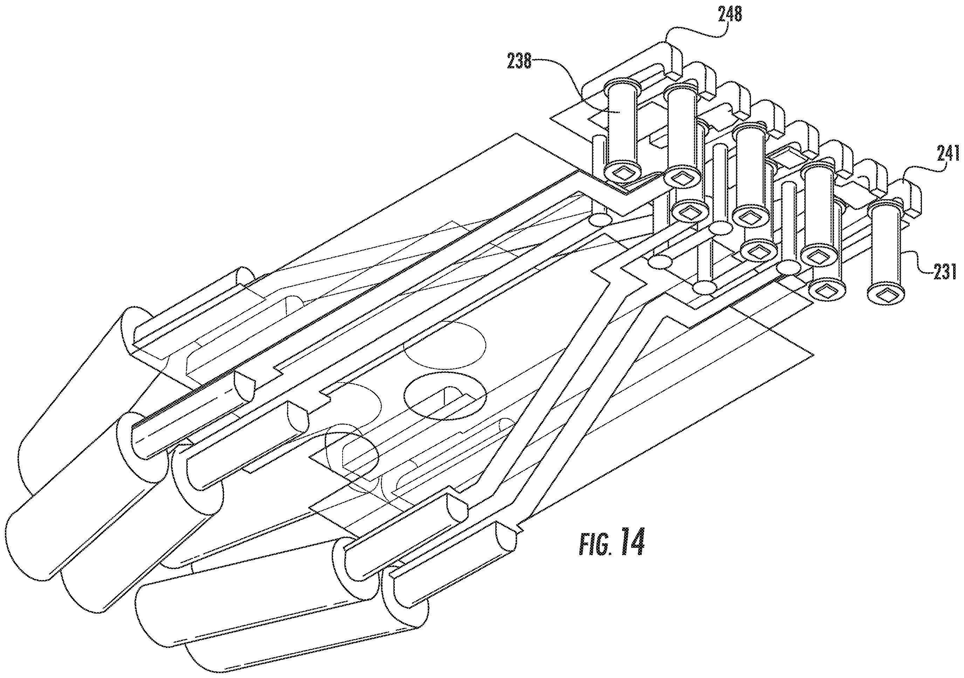

**FIGS. 11** and **12** are enlarged perspective top and bottom views, respectively, of the printed circuit board **250** and the plug blades **241-248** that illustrate these structures in greater detail and that show how the insulated conductors **201-208** of communications cable **209** may be electrically connected to the respective plug blades **241-248** through the printed circuit board **250**. **FIGS. 13** and **14** are enlarged perspective top and bottom views, respectively, of the top and bottom surfaces of the printed circuit board **250** and the plug blades **241-248**. In **FIGS. 13** and **14**, the dielectric portion of the printed circuit board **250** is omitted in order to better illustrate certain features of the printed circuit board **250**. In **FIG. 13**, only the base portions of the plug blades **241-248** are shown in order to illustrate how the base portion of each plug blade **241-248** is received within a respective one of a plurality of metal-plated vias **231-238** in the printed circuit board **250** in order to mount the plug blades **241-248** on the printed circuit board **250**.

The printed circuit board **250** may comprise, for example, a conventional printed circuit board, a specialized printed circuit board (e.g., a flexible printed circuit board) or any other appropriate type of wiring board. In the embodiment of the present invention depicted in **FIGS. 8-14**, the printed circuit board **250** comprises a conventional multi-layer printed circuit board.

As shown in the figures, the printed circuit board **250** includes four plated pads **251, 252, 254, 255** on a top surface thereof and an additional four plated pads **253, 256-258** on a bottom surface thereof. The insulation is removed from an end portion of each of the conductors **201-208** of the communications cable **209**, and the metal (e.g., copper) core of each conductor **201-208** may be soldered, welded or otherwise attached to a respective one of the plated pads **251-258**. By terminating each of the conductors **201-208** directly onto the plated pads **251-258** without the use of any insulation displacement contacts, insulation piercing contacts or other wire connection contacts, the size of the plug **216** may be reduced. It will also be appreciated that other techniques may be used for terminating the conductors **201-208** to the printed circuit board **250**. For example, in other embodiments, a plurality of insulation piercing contacts or insulation displacement contacts may be mounted on the printed circuit board **250** that are used to electrically connect each conductor **201-208** to a respective trace on the printed circuit board **250**. It will be appreciated that in other embodiments all of the conductors **201-208** may be mounted exclusively on the bottom surface of the printed circuit board **250** or exclusively on the top surface of the printed circuit board **250**.

As is best shown in **FIGS. 11-13,** the conductors **201-208** may be maintained in pairs within the plug **216**. A cruciform separator **230** may be included in the rear portion of the housing **220** that separates each pair **211-214** from the other pairs **211-214** in the cable **209** to reduce crosstalk in the plug **216**. The conductors **201-208** of each pair **211-214** may be maintained as a twisted pair all of the way from the rear opening **228** of plug **216** up to the printed circuit board **250**.

The plug blades **241-248** are configured to make mechanical and electrical contact with respective contacts, such as, for example, spring jackwire contacts, of a mating communications jack. In particular, as shown best in **FIGS. 11-12** and **14**, each of the eight plug blades **241-248** is mounted at the front portion of the printed circuit board **250**. The plug blades **241-248** may be substantially transversely aligned in side-by-side relationship. Each of the plug blades **241-248** includes a first section that extends forwardly along a top surface of the printed circuit board **250**, a transition section that curves through an angle of approximately ninety degrees and a second section that extends downwardly from the first section along a portion of the front edge of the printed circuit board **250**. The transition section may include a curved outer radius that complies with the specification set forth in, for example, IEC 60603-7-4 for industry standards compliant plug blades.

Each of the plug blades **241-248** may be fabricated separately from the printed circuit board **250**. In the depicted embodiment, each of the plug blades **241-248** comprise, for example, an elongated metal strip having a length of approximately 140 mils, a width of approximately 20 mils and a height (i.e., a thickness) of approximately 20 mils. Each plug blade **241-248** also includes a base column **249** (see **FIG. 13**) that extends from a bottom surface of the plug blade. The printed circuit board **250** includes eight metal-plated vias **231-238** that are arranged in two rows along the front edge thereof (only vias **231** and **238** are labeled in **FIG. 13** to simplify the drawing). The base column **249** of each plug blade **241-248** is received within a respective one of the metal-plated vias **231-238** where it may be press-fit, welded or soldered into place to mount the plug blades **241-248** on the printed circuit board **250**.

The plug blades **241-248** may be mounted to the printed circuit board **250** in other ways. For example, in other embodiments, elongated contact pads may be provided on the top surface of the printed circuit board **250** and each plug blade **241-248** may be welded or soldered to a respective one of these contact pads. It will be appreciated that many other attachment mechanisms may be used.

Turning again to **FIGS. 11-14** it can be seen that a plurality of conductive paths **261-268** are provided on the top and bottom surfaces of the printed circuit board **250**. Each of these conductive paths **261-268** electrically connects one of the plated pads **251-258** to a respective one of the metal-plated vias **231-238** so as to provide an electrical path between each of the conductors **201-208** that are terminated onto the plated pads **251-258** and a respective one of the plug blades **241-248** that are mounted in the metal-plated vias **231-238**. Each conductive path **261-268** may comprise, for example, one or more conductive traces that are provided on one or more layers of the printed circuit board **250**. When a conductive path **261-268** includes conductive traces that are on multiple layers of the printed circuit board **250** (i.e., conductive paths **264, 265** and **268** in the depicted embodiment), metal-plated or metal-filled through holes (or other layer-transferring structures known to those skilled in this art) may be provided that provide an electrical connection between the conductive traces on different layers of the printed circuit board **250**.

A total of four differential transmission lines **271-274** are provided through the plug **216**. The first differential transmission line **271** includes the end portions of conductors **204** and **205**, the plated pads **254** and **255**, the conductive traces **264** and **265**, the plug blades **244** and **245**, and the metal-plated vias **249** that are used to mount plug blades **244** and **245**. The second differential transmission line **272** includes the end portions of conductors **201** and **202**, the plated pads **251** and **252**, the conductive traces **261** and **262**, the plug blades **241** and **242**, and the metal-plated vias **249** that are used to mount plug blades **241** and **242**. The third differential transmission line **273** includes the end portions of conductors **203** and **206**, the plated pads **253** and **256**, the conductive traces **263** and **266**, the plug blades **243** and **246**, and the metal-plated vias **249** that are used to mount plug blades **243** and **246**. The fourth differential transmission line **274** includes the end portions of conductors **207** and **208**, the plated pads **257** and **258**, the conductive traces **267** and **268**, the plug blades **247** and **248**, and the metal-plated vias **249** that are used to mount plug blades **247** and **248**.

As shown in **FIGS. 11-14**, the two conductive traces **261-268** that form each of the differential transmission lines **271-274** on the printed circuit board **250** are generally run together, side-by-side, on the printed circuit board **250**. Running the conductive traces **261-268** of each differential transmission line **271-274** side-by-side may provide improved impedance matching so that each segment of a particular transmission line may have a relatively constant impedance. This approach may make it easier to model the performance of the transmission line and hence to design a transmission line that meets pre-selected performance criteria. As shown best in **FIGS. 13** and **14**, the conductive traces **264, 265** that are part of the transmission line **271** and the conductive traces **263, 266** that are part of the transmission line **273** each traverse the printed circuit board **250** at an angle with respect to the longitudinal axis of the printed circuit board **250**. These angled conductive traces are merely used for routing purposes to connect a pair of conductors (e.g., conductors **204** and **205**) that are located on one side of the longitudinal axis of the printed circuit board **250** to the metal-plated vias **234, 235**, which span the longitudinal axis of the printed circuit board **250**.

A plurality of offending crosstalk circuits are also included on the printed circuit board **250**. In particular, a total of five offending crosstalk capacitors **281-285** are provided adjacent the plug blades **241-248**. Capacitor **281** injects offending crosstalk between blades **241** and **242**, capacitor **282** injects offending crosstalk between blades **242** and **243**, capacitor **283** injects offending crosstalk between blades **243** and **244**, capacitor **284** injects offending crosstalk between blades **245** and **246**, and capacitor **285** injects offending crosstalk between blades **246** and **247**. Additionally, an inductive coupling section **286** is included between conductive traces **266** and **267** which injects offending inductive crosstalk between transmission lines **273** and **274** in order to meet the specified offending FEXT requirements in the Category 6a standard. The offending crosstalk circuits **281-286** may be provided, for example, to ensure that the plug **216** meets all of the pair-to-pair offending crosstalk specifications required by an industry standards document such as the aforementioned ANSI/TIA-568-C.2 standard. Unfortunately, these offending crosstalk circuits **281-286** appear as loads along each of the transmission lines **271-274** through the plug **216** that may make it difficult for the plug **216** to meet target return loss performance specifications, particularly at higher frequencies (e.g., frequencies above 500 MHz and even more so with respect to frequencies above 1 Ghz or above 1.5 GHz).

As discussed above, the communications connectors according to embodiments of the present invention may include two or more impedance mismatches along one or more of their transmission lines that improve the return loss on each transmission line over a desired frequency range. These impedance mismatches may create resonances that may be tuned to provide improved return loss and/or insertion loss performance for the transmission line over selected frequency ranges. The impedance mismatches can be implemented, for example, by changing the width or thickness of the conductors that form the differential transmission line segments or by changing the spacing of the conductors or the dielectric constants of the insulating materials that are adjacent to the conductors. By carefully selecting the degree of these impedance mismatches and the delays between the mismatches it is possible to significantly improve the return loss performance of the transmission line over a selected frequency range.

As is also shown in **FIGS. 13** and **14**, one or more reflection or "image" planes can be included in the plug **216.** In the embodiment of **FIGS. 7-14**, two image planes **290, 292** are included in the plug **216**, the first of which is located just below a top surface of the printed circuit board **250**, and a second of which is located just above a bottom surface of the printed circuit board **250.** Each image plane **290, 292** may be implemented as a conductive layer on the printed circuit board **250.** In some embodiments, the image planes **290, 292** may be grounded by, for example, connecting each image plane to a ground wire, drain wire or other ground reference so that each image plane **290, 292** will act as a ground plane. However, in other embodiments, the image planes **290, 292** may not be electrically grounded (i.e., they are left floating electrically). The image planes **290, 292**, whether or not they are electrically grounded, may act as shielding structures that reduce coupling between the portions of conductive traces **261-268** that are on the top side of the printed circuit board **250** and the portions of conductive traces **261-268** that are on the bottom side of the printed circuit board **250.**

The image planes **290, 292** may also be used to control the impedance of the transmission lines **271-274.** In particular, the impedance of each differential transmission line is impacted by the distance of the conductors of the transmission line **271-274** from the image plane(s) **290, 292.** Thus, another way of creating impedance mismatches along one or more of the transmission lines **271-274** in the plug **216** is to vary the distance of the conductors that form the transmission line from one of the image planes **290, 292.**

In the plug **216**, the impedance mismatches are created by varying the widths of the conductive traces **261-268**, varying the spacings between the conductive traces **261-268** and by varying the distances of the conductive traces from the image planes **290, 292** For example, conductive trace **261** includes a first transition point **261-1** where the trace narrows, a second transition point **261-2** where the trace narrows further, and a third transition point **261-3** where the trace widens. Each of these transition points **261-1** through **261-3** creates an impedance mismatch. Likewise, conductive trace **262** includes a first transition point **262-1** where the trace narrows and a second transition point **262-2** where the trace narrows further. These transition points create multiple impedance mismatches along transmission line **272.** Thus, multiple impedance mismatches are created along transmission line **272.**

In a similar fashion, transition points **263-1** and **263-2** are provided on conductive trace **263**, and transition points **266-1** and **266-2** are provided on conductive trace **263.** Additionally, near the front of the printed circuit board **250** conductive traces **263** and **267** split apart in order to be routed to their respective plug blades **243** and **246.** This increase in the spacing between conductive traces **263** and **266** create additional transition points **263-3** and **266-3.** These transition points create multiple impedance mismatches along transmission line **273.**

Similarly, conductive trace **267** of transmission line **274** includes two right angle turns adjacent the front edge of printed circuit board **250** that vary the spacing between conductive path **267** and its counterpart conductive path **268.** This variation in spacing creates additional impedance mismatches on conductive paths **267** and **268**, respectively. Additional impedance mismatches are injected on transmission line **274** via the transition points **267-1** and **268-1** that are provided on traces **267** and **268.** Thus, multiple impedance mismatches are also generated along transmission line **274.**

Finally, conductive trace **264** includes a first transition point **264-1** where the trace narrows, and conductive trace **265** likewise includes a first transition point **265-1** where the trace narrows. These transition points **264-1** through **265-1** create impedance mismatches. Another impedance mismatch occurs in the conductive vias that are used to transition the conductive traces from the top side of printed circuit board **250** to the bottom side of the printed circuit board **250.** The wide separation between conductive traces **264** and **265** near the front portion of printed circuit board **250** (i.e., on the bottom side of the board) also contributes to the impedance mismatch and further increases inductive coupling between transmission lines **271** and **273** for purposes of meeting the crosstalk specifications for plug **216.** Thus, multiple impedance mismatches are also created along transmission line **271.**

It can also be seen in **FIG. 13** and **14** that the image planes **290, 292** do not extent all the way forwardly to the front edge of the printed circuit board **250.** Another impedance mismatch is created where at the point where a conductive trace starts to extend beyond the front edge of an image plan, such as at transition points **261-2** and

262-2 for the conductive traces of transmission line **272**.

As discussed above, the number of impedance mismatches included on the conductors of a differential transmission line, the size of each impedance match, and the delays between impedance mismatches may be selected to enhance the return loss performance of the transmission line in a pre-selected frequency range. Trial and error approaches may be used to find a transmission line design that achieves desired performance levels, although computer programs may readily be developed that may be used to better optimize return loss performance.

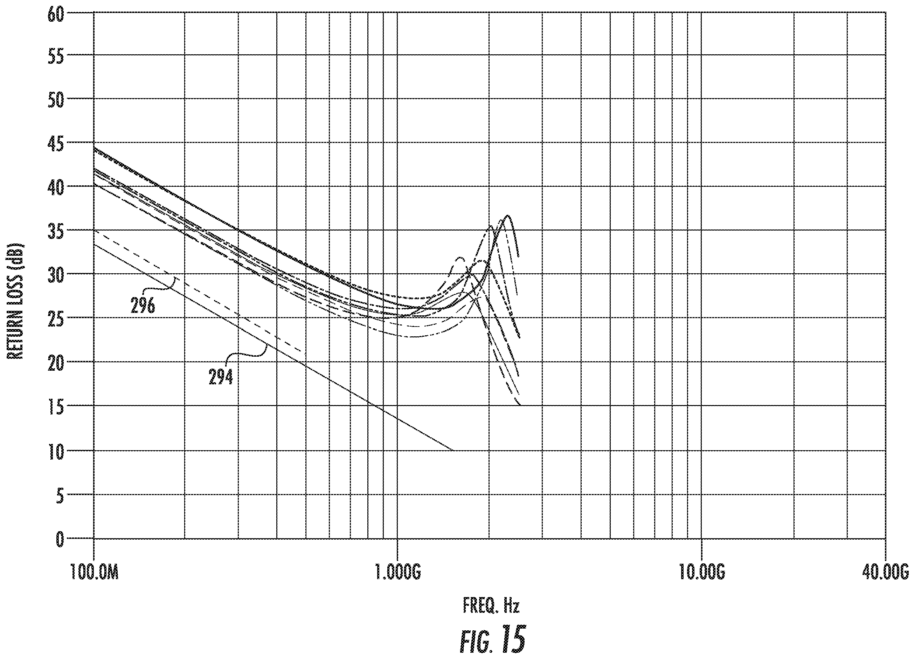

**FIG. 15** is a graph illustrating the simulated return loss performance of the communications plug **216** of **FIGS. 8-14**. In **FIG. 15**, the solid curves illustrate the simulated return loss on transmission lines **271-274** for signals passing in the forward direction through plug **216** (i.e., from the cable attached to the plug **216** to a mating jack), while the curves drawn using dotted lines illustrate the simulated return loss on transmission lines **271-274** for signals passing in the reverse direction through plug **216** (i.e., from a mating jack into the plug **216**). Curve **294** represents the minimum magnitude requirement for the Category 6a standard return loss (extrapolated above the Cat 6A requirement, which ends at 500 MHz). Curve **296** is the threshold above which the phase of the return loss need not be controlled. As is readily apparent, these simulations indicate that return loss margins of at least 6 dB are provided on all four transmission lines **271-274** at frequencies above 500 MHz.

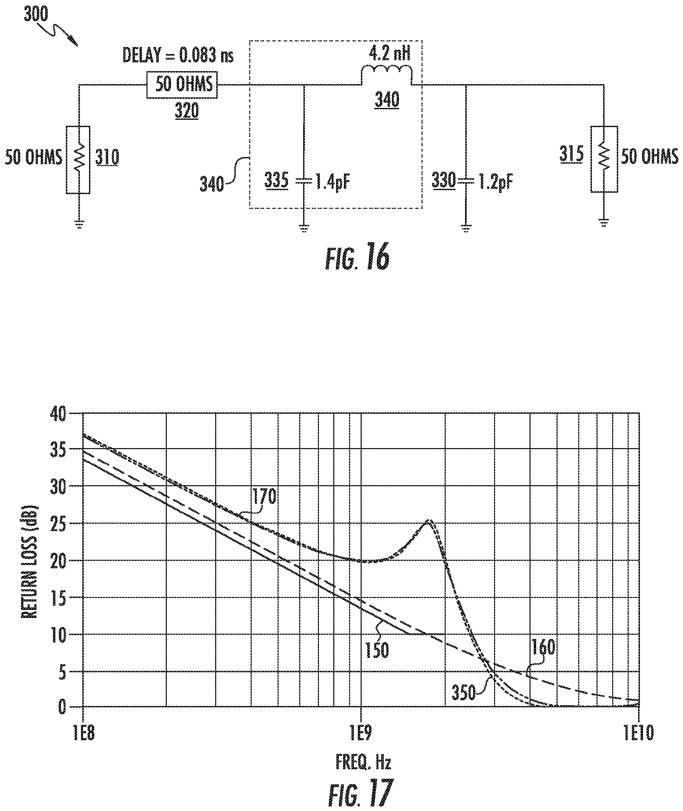

The resonances that are used to improve return loss on the transmission lines of connectors according to embodiments of the present invention may also be implemented using discrete elements. For example, **FIG. 16** illustrates an alternative circuit model for the transmission line of **FIG. 5**. As shown in **FIG. 16**, the transmission line **100'** of **FIG. 5** may alternatively be implemented as a transmission line **300** which includes a signal source with internal series termination **310**, a transmission line segment **320**, an end termination **315**, and a pi filter **340** which comprises a first 1.4 pF shunt capacitor **342**, the capacitive load **330** (1.2 pF) and a series 4.2 nH inductor **344** therebetween Each of the terminations **310, 315** are 50 ohm terminations, as is the transmission line segment **320**. The transmission line segment **320** is modeled as having a length that results in a delay of 0.083 nanoseconds (i.e., an RF signal will traverse each transmission line segment in 0.083 nanoseconds).

**FIG. 17** illustrates the return loss of the transmission line **100'** of **FIG. 5** (curve **170**) as compared to the return loss of the transmission line **300** of **FIG. 16** (curve **350**). As is readily apparent, the two curves are almost identical, which shows that the impedance mismatches create a low pass filtering effect that results in a local maximum in the return loss spectra that may be used to improve the return loss of the transmission line in a selected frequency range.

Pursuant to embodiments of the present invention, techniques are disclosed for improving the return loss performance of communications connectors, particularly at higher frequencies (e.g., frequencies above 500 MHz), as well as communications connectors that exhibit such improved return loss performance. The techniques according to embodiments of the present invention may be particularly suitable for use in Category 8 connectors that maintain backwards compatibility with the Category 6a standard, as the amount of offending crosstalk compensating crosstalk that is typically included in Category 6a standards-compliant connectors may appear as loads on the transmission lines through the connectors that can make it difficult to maintain good return loss performance at higher frequencies.

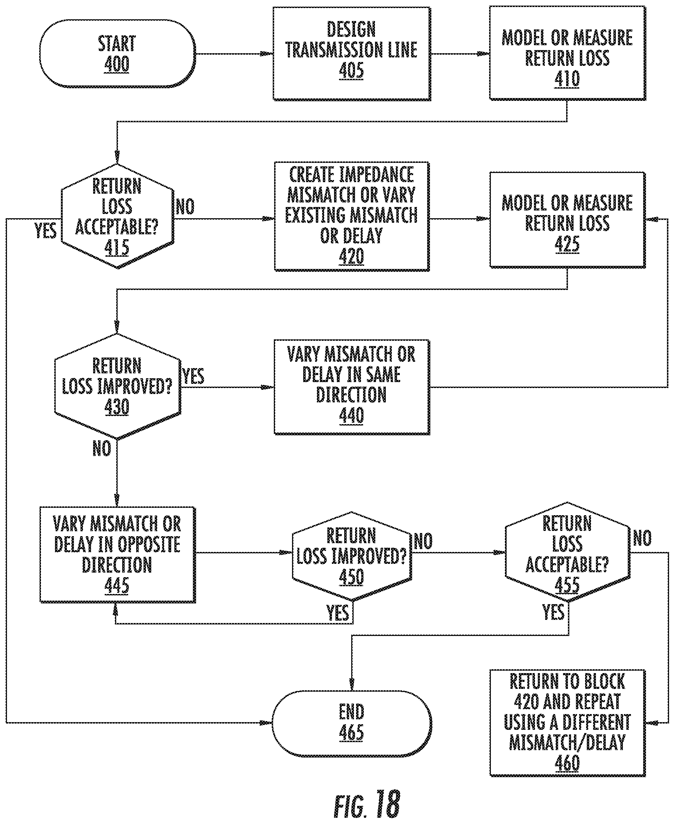

**FIG. 18** is a flow chart that illustrates a method of designing a transmission line for a communications connector according to certain embodiments of the present invention. As shown in **FIG. 18**, operations may start at block **400** with a circuit designer designing a transmission line of the connector (block **405**). This transmission line model may take into account loads that are placed on the transmission line such as crosstalk that is received from other transmission lines in the connector, transmission lines in adjacent connectors, etc. Once an initial design for the transmission line has been prepared, modeling techniques may be used to simulate the return loss performance of the transmission line, or alternatively, a test circuit may be built and the return loss performance may be measured (block **410**). At block **415**, a determination is made as to whether or not the modeled or measured return loss performance is acceptable. If it is, operations may then end (block **465**). If not, operations may then continue to block **420**, where the transmission line design is modified to include an impedance mismatch, the magnitude of an existing impedance mismatch is varied, and/or the delay between two impedance matches is varied.

Next, modeling techniques (or, alternatively, actual measurements) may be used to simulate the return loss performance of the modified transmission line design (block **425**). At block **430**, a determination is then made as to whether or not the return loss performance of the transmission line was improved in a desired fashion (e.g., within a certain frequency range) by the modifications of block **420**. If so, operations may proceed to block **440** where the change that was made to the transmission line design at block **420** is then increased further. For example, if at block **420**, an impedance mismatch was increased by 5%, then at block **440**, that same impedance mismatch may be increased by another 5%. As another example, if at block **420**, an impedance mismatch was decreased by 5%, then at block **440**, that same impedance mismatch may be decreased by another 3%. Operations then proceed back to block **425** where the return loss may be modeled again, and then operations proceed to block **420**.

If, at block **430** it is determined that the return loss performance was not improved, then operations proceed to block **445** where the change that was made to the transmission line design at block **420** is then removed and instead a change to the impedance mismatch or delay is made in the opposite direction. For example, if at block **420**, an impedance mismatch was increased by 5%, then at block **445**, the 5% increase in the impedance mismatch may be omitted and instead replaced with a 3% reduction in the impedance mismatch. Operations may then proceed to block **455**, where a determination is made as to whether the return loss performance is acceptable. If it is, operations may end (block **465**). If not, operations may return to block **420** and another impedance mismatch may be created or a different impedance mismatch or delay may be varied.

According to further embodiments of the present invention, the design method of **FIG. 18** may be modified as follows. After designing the transmission line at block **405**, measurements or simulation may be used to determine an approximate total value of the capacitive impairment $C_{imp}$ on the transmission line. This capacitive impairment value Cimp may inclue both within pair coupling and coupling to other transmission lines. Then at block **420**, a box section filter may be created by adding between the conductors of the transmission line at issue a capacitor $C_{in}$ that has a value of approximately $C_{imp}$, and by further adding two inductors L+ and L-, each which have an initial value of $1/(4*pi^2*C_{imp}*f^2)$, where f is the upper limit of the frequency range over which the return loss is to be improved. If this results in acceptable return loss performance, the method may then be terminated. If not, the values of one or more of $C_{imp}$, L+ and/or L- may be adjusted and the return loss performance may be re-simulated until acceptable return loss performance is achieved.

In some embodiments, communications connectors such as communications plugs (and patch cords that include such plugs) are provided that meet pre-determined performance criteria. For example, in some embodiments, communications plugs are provided that comply with the offending pair-to-pair crosstalk specifications set forth in the Category 6a standard, which is incorporated herein by reference, while each transmission line through the plug also maintains an average return loss of at least 15 dB over the frequency range from 1.0 GHz to 2.0 GHz. In other embodiments, these plugs can exhibit even higher return loss performance while complying with the offending pair-to-pair crosstalk specifications set forth in the Category 6a standard, such as having each transmission line through the plug maintain an average return loss of at least 20 dB over the frequency range from 1.0 GHz to 2.0 GHz or having each transmission line through the plug maintain an average return loss of at least 18 dB over the frequency range from 500 MHz to 1.5 GHz.

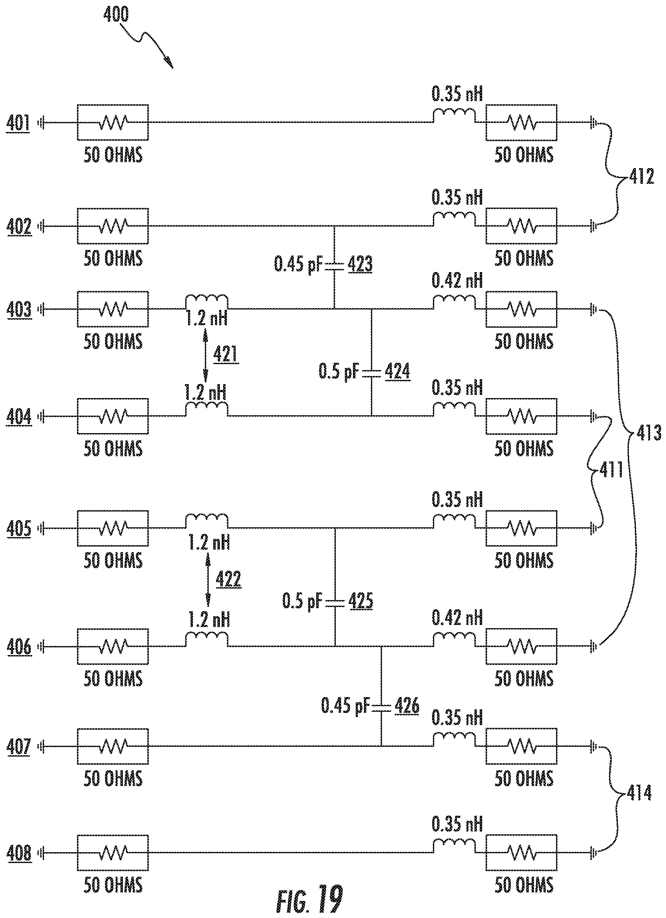

Pursuant to some embodiments of the present invention, the techniques discussed above may also be used to improve the return loss performance and/or the insertion loss performance of Cat 6a plugs. By way of example, **FIG. 19** is a circuit diagram of a model of a conventional Cat 6a test plug **400**. As shown in **FIG. 19**, the plug **400** includes a total of eight conductive paths **401-408** that are arranged a four differential transmission lines **411-414**. The plug **400** includes a plurality of loads including a first mutual inductance **421** where transmission lines **403** and **404** inductively couple and a second mutual inductance **422** where transmission lines **405** and **406** inductively couple, as well as capacitive couplings **423-426**. The loads **421-426** may be provided so that the plug meets the crosstalk requirements set forth in the Cat 6a standard.

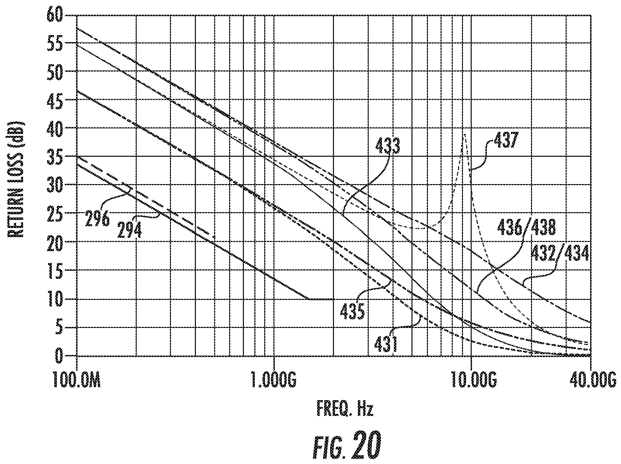

**FIG. 20** illustrates the simulated return loss of the plug **400** of **FIG. 19**. In **FIG. 20**, curves **431-434** indicate the return loss on the four transmission lines **411-414**, respectively, in the forward direction, and curves **435-438** indicate the return loss on the four transmission lines **411-414**, respectively, in the reverse direction (note that curves **432** and **434** overlap exactly and that curves **436** and **438** overlap exactly, so that **FIG. 20** appears to only have six curves as opposed to eight curves). As shown in **FIG. 20**, the test plug **400** may provide good performance. However, the plug **400** may also be difficult to implement. As is also shown in **FIG. 20**, inadvertent resonance occurs on at least some of the differential pairs, including a very clear resonance on pair 3 in the reverse direction (curve **437**) which results in a local maxima in the return loss on that pair. However, as is also apparent from **FIG. 20**, the improvement in return loss that is provided by this inadvertent resonance occurs well outside the frequency range of interest, and hence does nothing to improve the performance of the plug **400**.

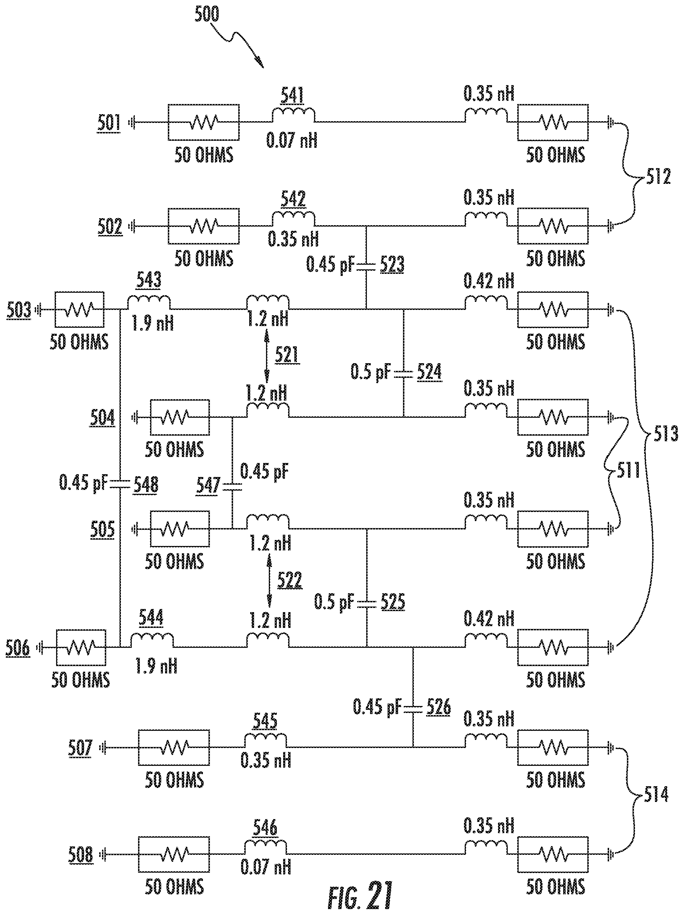

Pursuant to embodiments of the present invention, Cat 6a plugs may be provided that exhibit improved return loss performance. For example, **FIG. 21** is a circuit diagram of a Cat 6a plug **500** that includes discrete elements that generate impedance mismatches that are tuned to improve return loss and insertion loss performance. As shown in **FIG. 21**, the plug **500** is similar to the plug **400** of **FIG, 19** (note that elements **521-526** of plug **500** correspond exactly to elements **421-426** of plug **400**), but the plug **500** further includes additional discrete elements **541-548** that create impedance mismatches that are tuned to provide enhanced return loss performance.

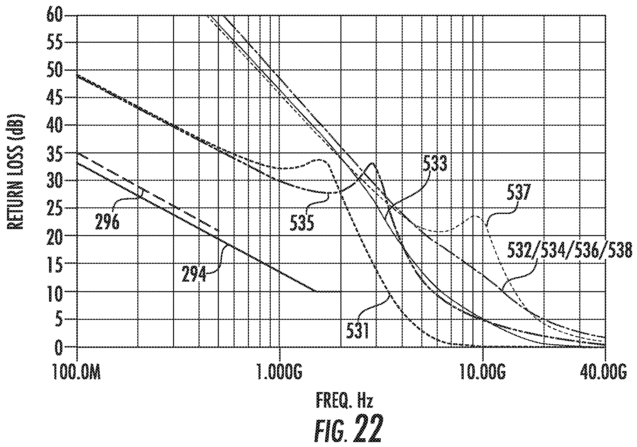

**FIG. 22** illustrates the simulated return loss of the plug **500** of **FIG. 21**. In **FIG. 22**, curves **531-534** indicate the return loss on the four transmission lines **511-514**, respectively, in the forward direction, and curves **535-538** indicate the return loss on the four transmission lines **511-514**, respectively, in the reverse direction (note that curves **532, 534, 536** and **538** overlap exactly so that **FIG. 22** appears to only have five curves as opposed to eight curves). As shown in **FIG. 22**, the test plug **500** may provide excellent performance, and may provide significantly better return loss performance as compared to the plug **400**.

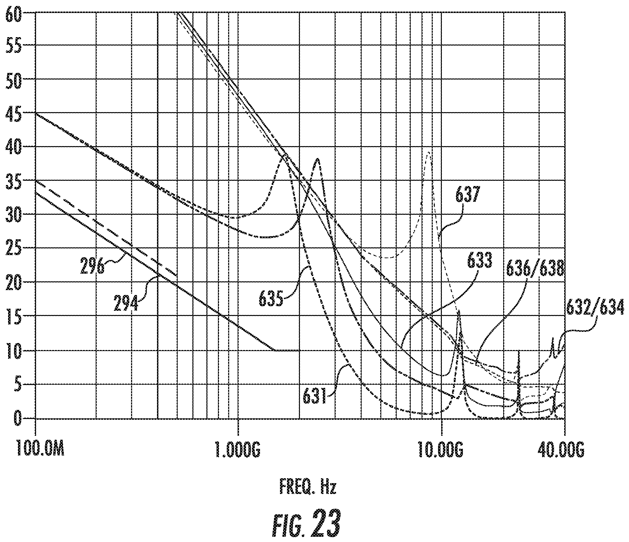

**FIG. 23** is a graph illustrating the simulated return loss performance of the transmission lines of another model of a Cat 6A plug that includes both discrete elements and transmission line impedance imbalances that together provide return loss and insertion loss enhancements. In **FIG. 23**, curves **631-634** indicate the return loss on the four transmission lines through the plug in the forward direction, and curves **635-638** indicate the return loss on the four transmission lines **511-514** through the plug in the reverse direction (note that curves **632, 634, 636** and **638** overlap exactly so that **FIG. 23** appears to only have five curves as opposed to eight curves). As shown in **FIG. 23**, this that also provides excellent return loss performance. Additionally, as can be seen in **FIG. 23** a plurality of peaks are generated in the return loss spectra for some of the pairs.

Pursuant to further embodiments of the present invention, methods of improving the return loss on a transmission line through a communications connector are provided in which a plurality of impedance mismatches are intentionally provided along the transmission line. These impedance mismatches may be caused by, for example, loads provided along the transmission line due to crosstalk circuits, discrete elements added along the transmission line to create impedance mismatches, and/or by changes in the characteristics of the transmission line (e.g., changing the width, thicknesses or spacing of the conductors thereof, changing the dielectric constants of surrounding materials, changing the relationship of the conductors with respect to image planes, etc.). Then, the magnitude of one or more of the impedance mismatches, the delay between one or more of the impedance mismatches and/or the number of impedance mismatches provided may be adjusted in order to reduce a rate of decrease in the return loss of the transmission line as a function of increasing frequency within a desired frequency operating range of the transmission line.

In some embodiments, the transmission line may be a differential transmission line through a plug of a patch cord. In some embodiments, the rate of decrease in the return loss of the transmission line as a function of increasing frequency may be reduced sufficiently such that a local maxima is generated in the return loss spectra.

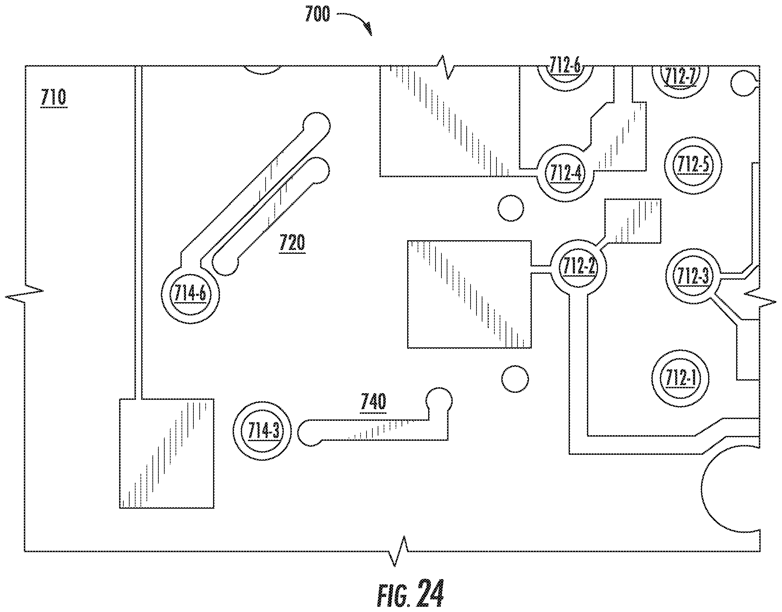

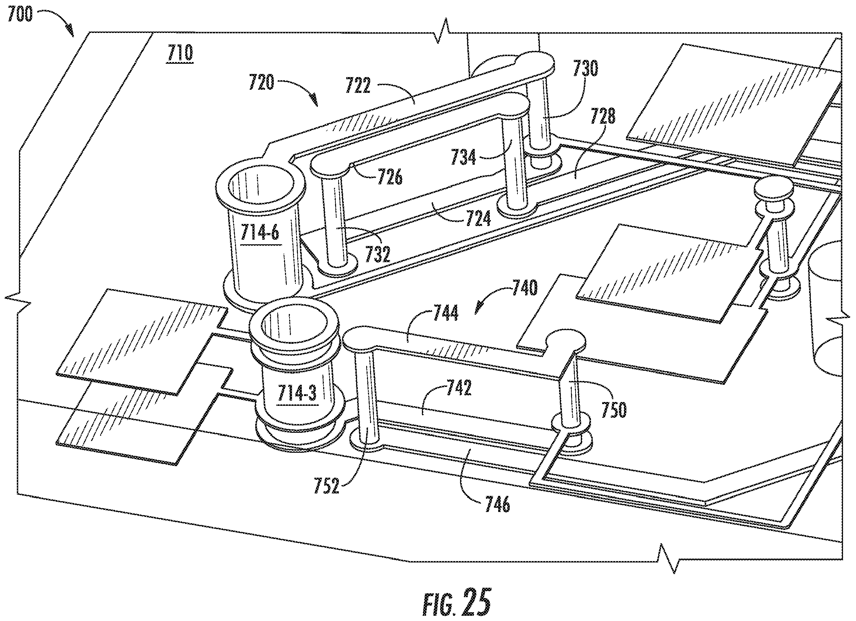

While embodiments of the present invention have been described above primarily with respect to communications plugs, it will be appreciated that the techniques disclosed herein are equally applicable to communications jacks. **FIGS. 24** and **25** illustrate a portion of a printed circuit board of a communications jack according to further embodiments of the present invention that includes electrical circuits in the form of inductors along a transmission line of the jack that create pre-selected impedance mismatches that are used to improve the return loss and/or the insertion loss of the transmission line over a desired frequency range. As discussed above, inductors that are used to create such impedance mismatches may be implemented by, for example, changing the width, thickness or spacing of the conductive traces/elements on the printed circuit board that form a transmission line segment or by including discrete inductors along the transmission line. In this particular embodiment, the inductors are implemented as discrete components in the form of solenoid inductors.

In particular, **FIG. 24** is a top view of a portion of a multi-layer printed circuit board **710** of an RJ-45 communications jack **700**. A pair of printed circuit board based solenoid inductors **720, 740** are implemented within the printed circuit board **710**. **FIG. 25** is an oblique view of a smaller portion of printed circuit board **710** that is illustrated in **FIG. 24** that shows the solenoid inductors **720, 740** in greater detail. In the particular embodiment of **FIGS. 24-25**, the solenoid inductors **720, 740** are implemented on the respective conductive paths through the printed circuit board **710** for pair 3 (see **FIG. 2**) of the RJ-45 jack. Each solenoid inductor **720, 740** is implemented as a single-turn solenoid, although it will be appreciated that additional turns could be included in other embodiments if larger series inductance values are needed.

As shown in **FIGS. 24-25**, the printed circuit board **710** includes a plurality of metal-plated holes **712** and a plurality of metal-plated holes **714**. The metal-plated holes **712** receive the eight jackwire contacts of the RJ-45 jack **700**. Only seven of the eight metal-plated holes **712** (namely holes **712-1** through **712-7**) are visible in the portion of the printed circuit board **710** shown in **FIG. 24**. The metal-plated holes **714** receive the eight insulation displacement contacts of the RJ-45 jack **700**. Only two of the eight metal-plated holes **714** (namely holes **714-3** and **714-6**) are visible in the portion of the printed circuit board **710** shown in **FIG. 24**. In **FIG. 25**, the dielectric material of the printed circuit board **710** is made translucent to illustrate conductive structures formed on layers of the printed circuit board **710** that are below the top layer, and only the conductive structures that are part of pair 3 are shown to simply **FIG. 25**.

Solenoid inductor **720** is formed in printed circuit board **710** using a plurality of conductive traces **722, 724, 726** and several conductive vias **730, 732, 734** that extend vertically through the printed circuit board **710**. The conductive traces **722, 724, 726** are relatively wide as they are signal current carrying traces that carry higher current levels. Conductive via **730** physically and electrically connects trace segment **722** to trace segment **724**. Conductive via **732** physically and electrically connects trace segment **724** to trace segment **726**. Conductive via **734** physically and electrically connects trace segment **726** to another trace segment **728** that connects (either directly or indirectly) to metal-plated hole **712-6** that receives a jackwire contact. The end of conductive trace **722** opposite conductive via **730** connects to the metal-plated insulation displacement contact hole **714-6**. The metal-plated via **714-6** is not deliberately implemented to be part of the solenoid inductor **720**, but because of the size of this structure and its location immediately adjacent the solenoid inductor **720** it will affect the inductances and hence the impact of the metal-plated hole **714-6** is accounted for when tuning the solenoid inductor **720**.

Similarly, the printed circuit board based solenoid inductor **740** is formed in printed circuit board **710** using a plurality of conductive traces **742, 744, 746** and two conductive vias **750, 752** that extend vertically through the printed circuit board **710**. Conductive via **750** physically and electrically connects trace segment **742** to trace segment **744**. Conductive via **752** physically and electrically connects trace segment **744** to trace segment **746**. Only two conductive vias **750, 752** are used to implement solenoid inductor **740** as conductive trace **746** continues on the same layer of printed circuit board **710**. Conductive trace segment **746** connects (either directly or indirectly) to metal-plated hole **712-3** that receives a jackwire contact. The end of conductive trace **742** opposite conductive via **750** connects to metal-plated insulation displacement contact hole **714-3**. The metal-plated hole **714-3** is not implemented to be part of the solenoid inductor **740**, but again because of its size and location immediately adjacent the solenoid inductor **740** it will affect the inductances, and hence the impact of the metal-plated hole **714-3** is accounted for when tuning the solenoid inductor **740**.

Solenoid inductor **720** acts to increase the impedance of the conductive path on printed circuit board **710** that connects metal-plated insulation displacement contact hole **714-6** to the metal-plated jackwire contact hole **712-6**. Solenoid inductor **740** acts to increase the impedance of the conductive path on printed circuit board **710** that connects metal-plated insulation displacement contact hole **714-3** to the metal-plated jackwire contact hole **712-3**. As a result, the impedance of the differential transmission line for pair 3 is increased. In an RJ-45 jack, return loss may be higher than desired because the impedance of the differential transmission line for pair 3 is below 100 ohms, and hence the solenoid inductors **720, 740** may increase the impedance of the differential transmission line for pair 3 and hence improve the return loss performance of the jack **700**.

The use of solenoid inductors **720, 740** may be advantageous because spirals of the needed inductance and current capacity may be too large to fit in the available space on the printed circuit board **710** for an RJ-45 jack. Additionally, the magnetic fields of solenoid inductors **720, 740** may be nearly perpendicular to those of other circuits such as crosstalk compensation circuits that are implemented on the printed circuit board **710**, and hence have less unintended parasitic coupling with such circuits.

The inductance of an isolated solenoid inductor is determined by the area of the loop current, the number of loops, and the effective magnetic permeability (mu) of the volume threaded by the magnetic field. Here, the magnetic permeability is equal to one because no ferrites or other such materials are present in the printed circuit board **710**, so the inductance is determined entirely by the geometry of the conductive traces and vias. In the embodiments of **FIGS. 24-25**, the two solenoid inductors **720, 740** are located close enough to one another so that they couple with each other (the magnetic field from each solenoid inductor **720, 740** partially threads through the other), creating a mutual inductance which affects the impedance of two solenoid inductors **720, 740** when considered/used as a differential pair.

The necessary inductance is achieved by adjusting the number of loops (here each solenoid inductor **720, 740** has a single loop), the lengths of the loops (their height is fixed by the thickness of the printed circuit board **710**), and the handedness or sense of the turns of each solenoid inductor **720, 740** (which controls whether the magnetic fields of each circuit will tend to add together and reinforce each other, or oppose each other). Here it is beneficial (more effective use of the space) to have the loops turn in opposite senses geometrically, which results in their magnetic fields reinforcing each other because the instantaneous currents in each circuit flow in opposite directions (they are members of a differential pair, so instantaneous current is flowing out of one insulation displacement contact while flowing into the other insulation displacement contact).

The solenoid inductors in the depicted embodiment are located near the metal-plated insulation displacement contact holes **714-3, 714-6**. In other embodiments, the solenoid inductors would not necessarily be close to the insulation displacement contacts holes **714**.

While the solenoid inductors **720, 740** each include a single loop, it will be appreciated that in other embodiments additional loops can be added by adding additional conductive trace segments and conductive vias having the same configuration immediately adjacent the first loop as part of the conductive path.

It will also be appreciated that the solenoid inductors that are disclosed herein may be used in other applications where it is desirable to implement a series inductance along a transmission line including, for example, other types of return loss circuits such as those disclosed in U.S. Patent No. 7,326,089 and/or in applications where series inductances are used in implementing frequency dependent crosstalk compensation circuits as disclosed, for example, in U.S. Patent No. 7,190,594. It will further be appreciated that the above-disclosed solenoid inductors may be implemented in communications plugs as well in further embodiments.

While the above embodiments have focused on connectors that include printed circuit boards, it will be appreciated that the techniques according to embodiments of the present invention may be implemented in connectors that do not include printed circuit boards such as plugs or jacks that use lead frame implementations.

While the above embodiments have focused on connectors that include differential transmission lines, it will be appreciated that the techniques according to embodiments of the present invention may also be implemented in connectors that use single-ended transmission lines. For example, in further embodiments, plugs may be provided in which one or more of the differential pairs are implemented as two single-ended transmission lines that have very low coupling with each other (and with the conductors of the remaining pairs) as opposed to using a single differential transmission line.

The present invention is not limited to the illustrated embodiments discussed above; rather, these embodiments are intended to fully and completely disclose the invention to those skilled in this art. In the drawings, like numbers refer to like elements throughout. Thicknesses and dimensions of some components may be exaggerated for clarity. The scope of the invention is defined by the claims.

Spatially relative terms, such as "top," "bottom," "side," "upper," "lower" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For "beneath" other elements or features would then be oriented "over" the other elements or features. Thus, the exemplary term "under" can encompass both an orientation of over and under. The device may be otherwise oriented (rotated 90 degrees or at other orientations) and the spatially relative descriptors used herein interpreted accordingly.

The present invention is directed to communications connectors such as RJ-45 plugs. As used herein, the terms "forward" and "front" and derivatives thereof refer to the direction defined by a vector extending from the center of the plug toward the portion of the plug that is first received within a plug aperture of a jack when the plug is mated with a jack. Conversely, the term "rearward" and derivatives thereof refer to the direction directly opposite the forward direction.

Well-known functions or constructions may not be described in detail for brevity and/or clarity. As used herein the expression "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises", "comprising", "includes" and/or "including" when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The foregoing is illustrative of the present invention and is not to be construed as limiting thereof. Although exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. The scope of the invention is defined by the appended claims.

## Claims

1. A communications connector, comprising:
   a printed circuit board having a plurality of input terminals (712), a plurality of output terminals (714), and a plurality of conductive paths (720, 740) that connect each input terminal to a respective output terminal, wherein the conductive paths (720, 740) are arranged as a plurality of differential transmission lines; **characterized in that** it further comprises a solenoid inductor (720) implemented along a first of the conductive paths (720), wherein the solenoid inductor (720) comprises a first trace segment (722) on a first layer of the printed circuit board, a second trace segment (724) on a second layer of the printed circuit board, a third trace segment (726) on the first layer of the printed circuit board adjacent the first trace segment (722), a first conductive via (730) directly connecting the first trace segment (722) to the second trace segment (724) and a second conductive via (732) directly connecting the second trace segment (724) to the third trace segment (726), the first, second and third segments (722, 724, 726) extending in a same direction, and wherein the second trace segment (724) vertically overlaps at least one of the first trace segment (722) or the third trace segment (726).

2. The communications connector of Claim 1, wherein the solenoid inductor comprises a first solenoid inductor (720), the communications connector further comprising a second solenoid inductor (740) implemented along a second of the conductive paths (740), the first and second conductive paths (720, 740) together forming a first of the differential transmission lines.

3. The communications connector of Claim 1, wherein the communications connector is an RJ-45 plug.

**4.** The communications connector of Claim 1, wherein the communications connector is an RJ-45 jack.

**5.** The communications connector of Claim 1 or 2, wherein the first trace segment (722) extends in parallel to the third trace segment (726).

**6.** The communications connector of Claim 2, wherein a handedness of the first solenoid inductor (720) is different than a handedness of the second solenoid inductor (740).

**7.** The communications connector of Claim 2, wherein a first magnetic field generated by the first solenoid inductor (720) reinforces a second magnetic field generated by the second solenoid inductor (740).

**8.** The communications connector of Claim 2, wherein the first solenoid inductor (720) is configured to increase an impedance of the first of the differential transmission lines.

**9.** The communications connector of Claim 1, wherein the solenoid inductor (720) includes at least two loops.

**10.** The communications connector of Claim 1, wherein a first magnetic field generated by the solenoid inductor (720) is nearly perpendicular to a second magnetic field generated by a crosstalk compensation circuit that is implemented on the printed circuit board.

**11.** The communications connector of Claim 1, wherein the first layer of the printed circuit board is an uppermost layer of the printed circuit board and the second layer of the printed circuit board is a lowermost layer of the printed circuit board.

**12.** The communications connector of Claim 1, wherein the solenoid inductor (720) is immediately adjacent a metal plated hole (714) in the printed circuit board that receives an insulation displacement contact.

**13.** The communications connector of Claim 2, wherein the first solenoid inductor (720) and the second solenoid inductor (740) are positioned so that their magnetic fields couple.

**Patentansprüche**

**1.** Kommunikationsverbinder, umfassend:
eine Leiterplatte mit mehreren Eingangsanschlüssen (712), mehreren Ausgangsanschlüssen (714) und mehreren Leiterbahnen (720, 740), die jeden Eingangsanschluss mit einem entsprechenden Ausgangsanschluss verbinden, wobei die Leiterbahnen (720, 740) als mehrere differenzielle Übertragungsleitungen angeordnet sind; **dadurch gekennzeichnet, dass** er ferner eine Magnetspule (720) umfasst, die entlang einer ersten der Leiterbahnen (720) implementiert ist, wobei die Magnetspule (720) ein erstes Spursegment (722) auf einer ersten Schicht der Leiterplatte umfasst, ein zweites Spursegment (724) auf einer zweiten Schicht der Leiterplatte, ein drittes Spursegment (726) auf der ersten Schicht der Leiterplatte neben dem ersten Spursegment (722), eine erste leitende Durchkontaktierung (730), die das erste Spursegment (722) direkt mit dem zweiten Spursegment (724) verbindet, und eine zweite leitende Durchkontaktierung (732), die das zweite Spursegment (724) direkt mit dem dritten Spursegment (726) verbindet, wobei sich das erste, das zweite und das dritte Segment (722, 724, 726) in einer gleichen Richtung erstrecken, und wobei das zweite Spursegment (724) mindestens eines von dem ersten Spursegment (722) oder dem dritten Spursegment (726) vertikal überlappt.

**2.** Kommunikationsverbinder nach Anspruch 1, wobei die Magnetspule eine erste Magnetspule (720) umfasst, der Kommunikationsverbinder ferner eine zweite Magnetspule (740) umfasst, die entlang einer zweiten der Leiterbahnen (740) implementiert ist, und die erste und die zweite Leiterbahn (720, 740) zusammen eine erste der differenziellen Übertragungsleitungen bilden.

**3.** Kommunikationsverbinder nach Anspruch 1, wobei der Kommunikationsverbinder ein RJ-45-Stecker ist.

**4.** Kommunikationsverbinder nach Anspruch 1, wobei der Kommunikationsverbinder eine RJ-45-Buchse ist.

**5.** Kommunikationsverbinder nach Anspruch 1 oder 2, wobei sich das erste Spursegment (722) parallel zu dem dritten Spursegment (726) erstreckt.

**6.** Kommunikationsverbinder nach Anspruch 2, wobei sich eine Händigkeit der ersten Magnetspule (720) von einer Händigkeit der zweiten Magnetspule (740) unterscheidet.

**7.** Kommunikationsverbinder nach Anspruch 2, wobei ein erstes Magnetfeld, das von der ersten Magnetspule (720) erzeugt wird, ein zweites Magnetfeld verstärkt, das von der zweiten Magnetspule (740) erzeugt wird.

**8.** Kommunikationsverbinder nach Anspruch 2, wobei die erste Magnetspule (720) konfiguriert ist, eine Impedanz der ersten der differenziellen Übertragungsleitungen zu erhöhen.

**9.** Kommunikationsverbinder nach Anspruch 1, wobei die Magnetspule (720) mindestens zwei Schleifen umfasst.

**10.** Kommunikationsverbinder nach Anspruch 1, wobei ein erstes Magnetfeld, das von der Magnetspule (720) erzeugt wird, nahezu senkrecht zu einem zweiten Magnetfeld ist, das von einer Übersprechkompensationsschaltung erzeugt wird, die auf der Leiterplatte implementiert ist.

**11.** Kommunikationsverbinder nach Anspruch 1, wobei die erste Schicht der Leiterplatte eine oberste Schicht der Leiterplatte ist und die zweite Schicht der Leiterplatte eine unterste Schicht der Leiterplatte ist.

**12.** Kommunikationsverbinder nach Anspruch 1, wobei sich die Magnetspule (720) unmittelbar neben einem metallplattiertes Loch (714) in der Leiterplatte befindet, das einen Schneidklemmkontakt aufnimmt.

**13.** Kommunikationsverbinder nach Anspruch 2, wobei die erste Magnetspule (720) und die zweite Magnetspule (740) derart positioniert sind, dass sich ihre Magnetfelder koppeln.

**Revendications**

**1.** Connecteur de communication, comprenant :
une carte de circuit imprimé ayant une pluralité de bornes d'entrée (712), une pluralité de bornes de sortie (714) et une pluralité de chemins conducteurs (720, 740) qui connectent chaque borne d'entrée à une borne de sortie respective, dans lequel les chemins conducteurs (720, 740) sont agencés sous la forme d'une pluralité de lignes de transmission différentielles ; **caractérisé en ce qu'**il comprend en outre un inducteur solénoïde (720) implémenté le long d'un premier des chemins conducteurs (720), dans lequel l'inducteur solénoïde (720) comprend un premier segment de trace (722) sur une première couche de la carte de circuit imprimé, un deuxième segment de trace (724) sur une deuxième couche de la carte de circuit imprimé, un troisième segment de trace (726) sur la première couche de la carte de circuit imprimé adjacent au premier segment de trace (722), un premier via conducteur (730) connectant directement le premier segment de trace (722) au deuxième segment de trace (724) et un deuxième via conducteur (732) connectant directement le deuxième segment de trace (724) au troisième segment de trace (726), les premier, deuxième et troisième segments (722, 724, 726) s'étendant dans une même direction, et dans lequel le deuxième segment de trace (724) chevauche verticalement au moins un parmi le premier segment de trace (722) ou le troisième segment de trace (726).

**2.** Connecteur de communication selon la revendication 1, dans lequel l'inducteur solénoïde comprend un premier inducteur solénoïde (720), le connecteur de communication comprenant en outre un deuxième inducteur solénoïde (740) implémenté le long d'un deuxième parmi les chemins conducteurs (740), les premier et deuxième chemins conducteurs. (720, 740) formant ensemble une première des lignes de transmission différentielles.

**3.** Connecteur de communication selon la revendication 1, dans lequel le connecteur de communication est une fiche RJ-45.

**4.** Connecteur de communication selon la revendication 1, dans lequel le connecteur de communication est une prise RJ-45.

**5.** Connecteur de communication selon la revendication 1 ou 2, dans lequel le premier segment de trace (722) s'étend en parallèle au troisième segment de trace (726).

**6.** Connecteur de communication selon la revendication 2, dans lequel une sensibilité du premier inducteur solénoïde (720) est différente de la sensibilité du deuxième inducteur solénoïde (740).

**7.** Connecteur de communication selon la revendication 2, dans lequel un premier champ magnétique généré par le premier inducteur solénoïde (720) renforce un deuxième champ magnétique généré par le deuxième inducteur solénoïde (740).

**8.** Connecteur de communication selon la revendication 2, dans lequel le premier inducteur solénoïde (720) est configuré pour augmenter une impédance de la première parmi les lignes de transmission différentielles.

**9.** Connecteur de communication selon la revendication 1, dans lequel l'inducteur solénoïde (720) comprend au moins deux boucles.

**10.** Connecteur de communication selon la revendication 1, dans lequel un premier champ magnétique généré par l'inducteur solénoïde (720) est presque perpendiculaire à un deuxième champ magnétique généré par un circuit de compensation de diaphonie qui est mis en œuvre sur la carte de circuit imprimé.

**11.** Connecteur de communication selon la revendication 1, dans lequel la première couche de la carte de circuit imprimé est une couche la plus haute de la carte de circuit imprimé et la deuxième couche de la carte de circuit imprimé est une couche la plus basse de la carte de circuit imprimé.

12. Connecteur de communication selon la revendication 1, dans lequel l'inducteur solénoïde (720) est immédiatement adjacente à un trou métallisé (714) dans la carte de circuit imprimé qui reçoit un contact de déplacement d'isolation.

13. Connecteur de communication selon la revendication 2, dans lequel le premier inducteur solénoïde (720) et le deuxième inducteur solénoïde (740) sont positionnés de sorte que leurs champs magnétiques se couplent.

FIG. 1
(PRIOR ART)

PAIR 3

PAIR 2     PAIR 1     PAIR 4

1  2  3  4  5  6  7  8

FIG. 2
(PRIOR ART)

100

DELAY = 0.083 ns

50 OHMS
120

50 OHMS ⌇ 110

1.2pF ⊣⊢130    115 ⌇ 50 OHMS

*FIG. 3*

40 ┬
35 ┤
30 ┤
RETURN LOSS (dB)
25 ┤    170
20 ┤    175
15 ┤
10 ┤    150
5 ┤    160
0 ┴
1E8        1E9        1E10
FREQ. Hz

*FIG. 4A*

21

EP 3 381 093 B1

FIG. 4B

FIG. 5

22

*FIG. 6*

*FIG. 7*

FIG. 8

**FIG. 9**

**FIG. 10**

FIG. 11

FIG. 12

FIG. 13

FIG. 14

248

238

241

231

EP 3 381 093 B1

28

*FIG. 15*

EP 3 381 093 B1

**DELAY = 0.083 ns**

50 OHMS
**320**

4.2 nH
**340**

50 OHMS ⌇ **310**

**340**

**335** ╪1.4pF

**330**╪1.2pF

**315** ⌇ 50 OHMS

300

*FIG. 16*

*FIG. 17*

START
400

DESIGN
TRANSMISSION LINE
405

MODEL OR MEASURE
RETURN LOSS
410

RETURN
LOSS
ACCEPTABLE?
415

NO

YES

CREATE IMPEDANCE
MISMATCH OR VARY
EXISTING MISMATCH
OR DELAY
420

MODEL OR MEASURE
RETURN LOSS
425

RETURN
LOSS IMPROVED?
430

YES

VARY MISMATCH OR
DELAY IN SAME
DIRECTION
440

NO

VARY MISMATCH OR
DELAY IN OPPOSITE
DIRECTION
445

RETURN
LOSS IMPROVED?
450

NO

RETURN
LOSS
ACCEPTABLE?
455

NO

YES

YES

END
465

RETURN TO BLOCK
420 AND REPEAT
USING A DIFFERENT
MISMATCH/DELAY
460

FIG. 18

31

400

FIG. 19

FIG. 20

FIG. 21

FIG. 22

FREQ. Hz

*FIG. 23*

FIG. 24

EP 3 381 093 B1

FIG. 25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5997358 A, Adriaenssens
- US 2013210289 A1
- EP 1347475 A1
- US 2006226943 A1
- US 7326089 B
- US 7190594 B

**Non-patent literature cited in the description**

- ANSI/TIA-568-C.2 standard approved. the Telecommunications Industry Association, 11 August 2009